# EUROPEAN PATENT SPECIFICATION

(11) **EP 4 505 457 B1**
(45) Date of publication and mention of the grant of the patent: **26.08.2026**
(21) Application number: 22751588.9
(22) Date of filing: 14.07.2022
(51) Int. Cl.: G11C 11/54, G11C 7/14, G11C 7/10, G11C 17/10, G11C 16/04, G11C 29/02, G11C 29/24, G11C 29/26, G06N 3/0442, G06N 3/0464, G06N 3/048, G06N 3/063, G06N 3/065

(54) **ARTIFICIAL NEURAL NETWORK COMPRISING REFERENCE ARRAY FOR I-V SLOPE CONFIGURATION**
KÜNSTLICHES NEURONALES NETZWERK MIT REFERENZARRAY ZUR I-V-STEIGUNGSKONFIGURATION
RÉSEAU NEURONAL ARTIFICIEL COMPRENANT UN RÉSEAU DE RÉFÉRENCE POUR UNE CONFIGURATION DE PENTE I-V

(30) Priority: 07.04.2022 US 202263328543 P; 23.06.2022 US 202217848381
(43) Date of publication of application: 12.02.2025
(73) Proprietor: Silicon Storage Technology Inc., San Jose CA 95134 (US)
(72) Inventor: TRAN, Hieu Van, San Jose, California 95135 (US); VU, Thuan, San Jose, California 95138 (US); HONG, Stanley, San Jose, California 95131 (US); TRINH, Stephen, San Jose, California 95148 (US); LEMKE, Steven, Boulder Creek, California 95006 (US); SCHNEIDER, Louisa, San Jose, California 95134 (US); DO, Nhan, Saratoga, California 95070 (US)
(74) Representative: Betten & Resch
(86) International application number: PCT/US2022/037229
(87) International publication number: WO 2023/195999

(56) References cited:
- EP-A1- 3 467 834
- US-A1- 2014 369 141
- US-A1- 2020 019 848

## Description

### PRIORITY CLAIMS

This application claims priority to U.S. Provisional Patent Application No. 63/328,543, filed on April 7, 2022, and titled, "Artificial Neural Network Comprising Monte Carlo Reference Array for I-V Slope Configuration," and, U.S. Patent Application No. 17/848,381, filed on June 23, 2022, and titled, "Artificial Neural Network Comprising Reference Array for I-V Slope Configuration."

### FIELD OF THE INVENTION

Numerous examples are disclosed of an artificial neural network comprising a reference array used for I-V slope configuration in the main array.

US 2020019848 A1 discloses that numerous embodiments are disclosed for compensating for differences in the slope of the current-voltage characteristic curve among reference transistors, reference memory cells, and flash memory cells during a read operation in an analog neural memory in a deep learning artificial neural network. The embodiments are able to compensate for slope differences during both sub-threshold and linear operation of reference transistors.

US 20140369141 A1 discloses selecting an array from among a plurality of arrays in a memory as a reference array. An exemplary method includes evaluating memory cells within the reference array to select a first reference cell associated with a first operation of the memory, and repeating the evaluating and the selecting to select a second reference cell from within the reference array, the second reference cell being associated with a second operation of the memory.

EP 3467834 A1 discloses that an integrated circuit includes an artificial intelligence (AI) logic and an embedded memory coupled to the AI logic and connectable to an external processor. The embedded memory includes multiple storage cells and multiple reference units. One or more reference units in the memory are selected for memory access through configuration at chip packaging level by the external processor. The external processor may execute a self-test process to select or update the one or more reference units for memory access so that the error rate of memory is below a threshold. The self-test process may be performed, via a memory initialization controller in the memory, to test and reuse the reference cells in the memory at chip level. The embedded memory may be a STT-MRAM, SOT, OST MRAM, and/or MeRAM memory.

### BACKGROUND OF THE INVENTION

Artificial neural networks mimic biological neural networks (the central nervous systems of animals, in particular the brain) and are used to estimate or approximate functions that can depend on a large number of inputs and are generally unknown. Artificial neural networks generally include layers of interconnected "neurons" which exchange messages between each other.

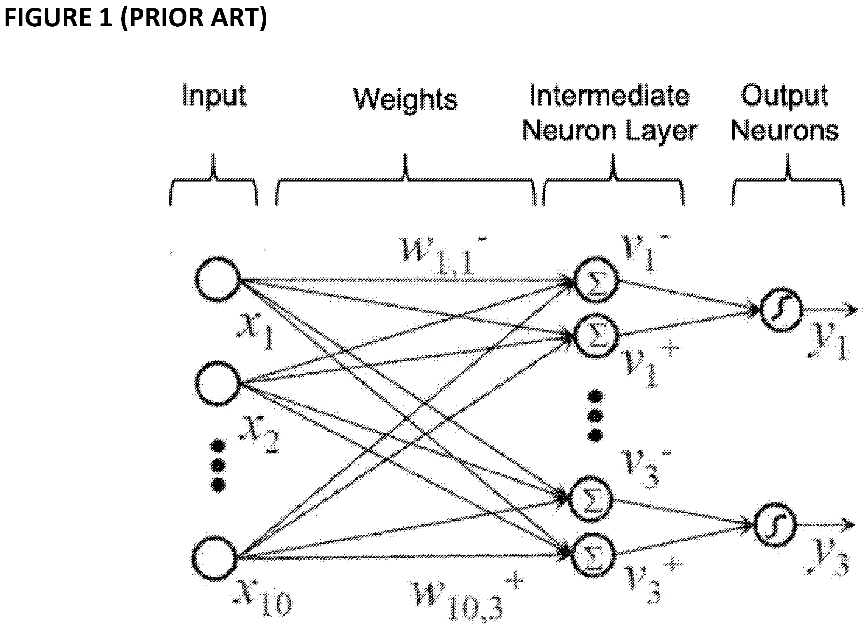

Figure 1 illustrates an artificial neural network, where the circles represent the inputs or layers of neurons. The connections (called synapses) are represented by arrows and have numeric weights that can be tuned based on experience. This makes neural networks adaptive to inputs and capable of learning. Typically, neural networks include a layer of multiple inputs. There are typically one or more intermediate layers of neurons, and an output layer of neurons that provide the output of the neural network. The neurons at each level individually or collectively make a decision based on the received data from the synapses.

One of the major challenges in the development of artificial neural networks for high-performance information processing is a lack of adequate hardware technology. Indeed, practical neural networks rely on a very large number of synapses, enabling high connectivity between neurons, i.e., a very high computational parallelism. In principle, such complexity can be achieved with digital supercomputers or specialized graphics processing unit clusters. However, in addition to high cost, these approaches also suffer from mediocre energy efficiency as compared to biological networks, which consume much less energy primarily because they perform low-precision analog computation. CMOS analog circuits have been used for artificial neural networks, but most CMOS-implemented synapses have been too bulky given the high number of neurons and synapses.

Applicant previously disclosed an artificial (analog) neural network that utilizes one or more non-volatile memory arrays as the synapses in U.S. Patent Application Publication 2017/0337466A1, which is incorporated by reference. The non-volatile memory arrays operate as an analog neural memory and comprise non-volatile memory cells arranged in rows and columns. The neural network includes a first plurality of synapses configured to receive a first plurality of inputs and to generate therefrom a first plurality of outputs, and a first plurality of neurons configured to receive the first plurality of outputs. The first plurality of synapses includes a plurality of memory cells, wherein each of the memory cells includes spaced apart source and drain regions formed in a semiconductor substrate with a channel region extending there between, a floating gate disposed over and insulated from a first portion of the channel region and a non-floating gate disposed over and insulated from a second portion of the channel region. Each of the plurality of memory cells store a weight value corresponding to a number of electrons on the floating gate. The plurality of memory cells multiply the first plurality of inputs by the stored weight values to generate the first plurality of outputs.

### Non-Volatile Memory Cells

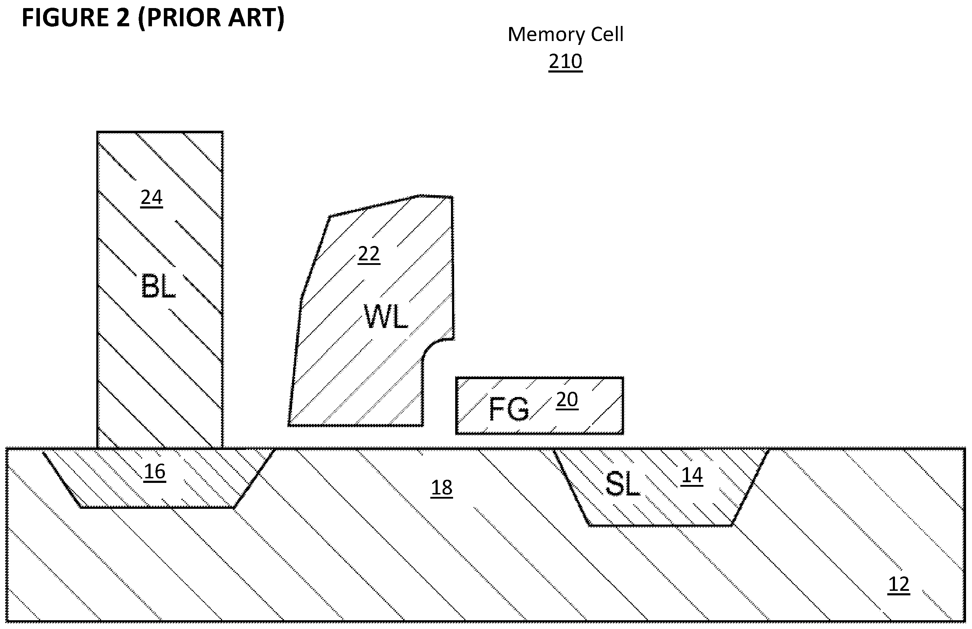

Non-volatile memories are well known. For example, U.S. Patent 5,029,130 ("the '130 patent"), which is incorporated herein by reference, discloses an array of split gate non-volatile memory cells, which are a type of flash memory cells. Such a memory cell 210 is shown in Figure 2. Each memory cell 210 includes source region 14 and drain region 16 formed in semiconductor substrate 12, with channel region 18 there between. Floating gate 20 is formed over and insulated from (and controls the conductivity of) a first portion of the channel region 18, and over a portion of the source region 14. Word line terminal 22 (which is typically coupled to a word line) has a first portion that is disposed over and insulated from (and controls the conductivity of) a second portion of the channel region 18, and a second portion that extends up and over the floating gate 20. The floating gate 20 and word line terminal 22 are insulated from the substrate 12 by a gate oxide. Bitline 24 is coupled to drain region 16.

Memory cell 210 is erased (where electrons are removed from the floating gate) by placing a high positive voltage on the word line terminal 22, which causes electrons on the floating gate 20 to tunnel through the intermediate insulation from the floating gate 20 to the word line terminal 22 via Fowler-Nordheim (FN) tunneling.

Memory cell 210 is programmed by source side injection (SSI) with hot electrons (where electrons are placed on the floating gate) by placing a positive voltage on the word line terminal 22, and a positive voltage on the source region 14. Electron current will flow from the drain region 16 towards the source region 14. The electrons will accelerate and become heated when they reach the gap between the word line terminal 22 and the floating gate 20. Some of the heated electrons will be injected through the gate oxide onto the floating gate 20 due to the attractive electrostatic force from the floating gate 20.

Memory cell 210 is read by placing positive read voltages on the drain region 16 and word line terminal 22 (which turns on the portion of the channel region 18 under the word line terminal). If the floating gate 20 is positively charged (i.e., erased of electrons), then the portion of the channel region 18 under the floating gate 20 is turned on as well, and current will flow across the channel region 18, which is sensed as the erased or "1" state. If the floating gate 20 is negatively charged (i.e., programmed with electrons), then the portion of the channel region under the floating gate 20 is mostly or entirely turned off, and current will not flow (or there will be little flow) across the channel region 18, which is sensed as the programmed or "0" state.

Table No. 1 depicts typical voltage and current ranges that can be applied to the terminals of memory cell 210 for performing read, erase, and program operations:

**Table No. 1: Operation of Flash Memory Cell 210 of Figure 2**

| | WL | BL | SL |
|---|---|---|---|
| Read | 2-3V | 0.6-2V | 0V |
| Erase | ~11-13V | 0V | 0V |
| Program | 1-2V | 10.5-3µA | 9-10V |

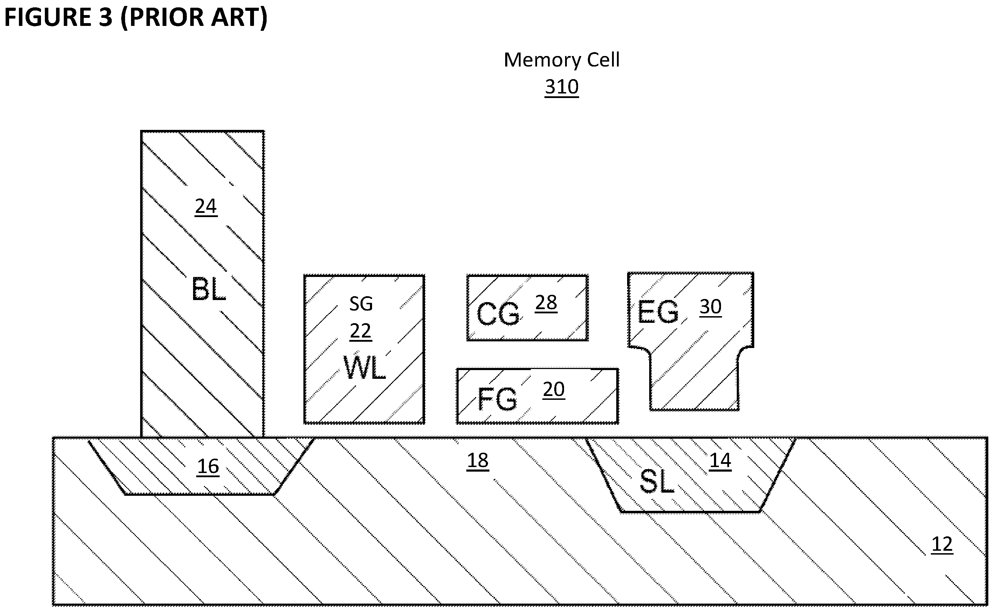

Other split gate memory cell configurations, which are other types of flash memory cells, are known. For example, Figure 3 depicts a four-gate memory cell 310 comprising source region 14, drain region 16, floating gate 20 over a first portion of channel region 18, a select gate 22 (typically coupled to a word line, WL) over a second portion of the channel region 18, a control gate 28 over the floating gate 20, and an erase gate 30 over the source region 14. This configuration is described in U.S. Patent 6,747,310, which is incorporated herein by reference for all purposes. Here, all gates are non-floating gates except floating gate 20, meaning that they are electrically connected or connectable to a voltage source. Programming is performed by heated electrons from the channel region 18 injecting themselves onto the floating gate 20. Erasing is performed by electrons tunneling from the floating gate 20 to the erase gate 30.

Table No. 2 depicts typical voltage and current ranges that can be applied to the terminals of memory cell 310 for performing read, erase, and program operations:

**Table No. 2: Operation of Flash Memory Cell 310 of Figure 3**

| | WL/SG | BL | CG | EG | SL |
|---|---|---|---|---|---|
| Read | 1.0-2V | 0.6-2V | 0-2.6V | 0-2.6V | 0V |
| Erase | -0.5V/0V | 0V | 0V/-8V | 8-12V | 0V |
| Program | 1V | 0.1-1µA | 8-11V | 4.5-9V | 4.5-5V |

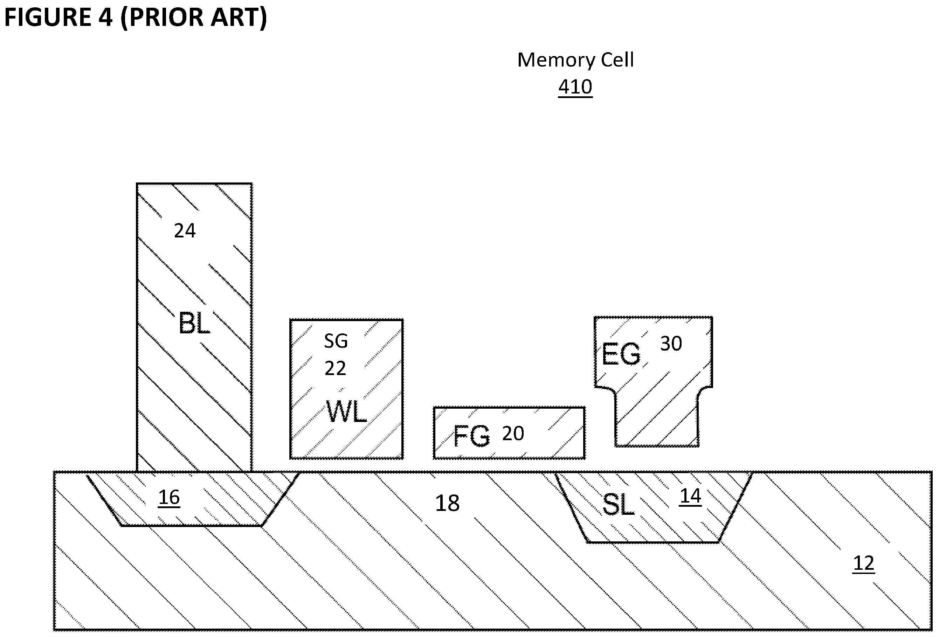

Figure 4 depicts a three-gate memory cell 410, which is another type of flash memory cell. Memory cell 410 is identical to the memory cell 310 of Figure 3 except that memory cell 410 does not have a separate control gate. The erase operation (whereby erasing occurs through use of the erase gate) and read operation are similar to that of the Figure 3 except there is no control gate bias applied. The programming operation also is done without the control gate bias, and as a result, a higher voltage is applied on the source line during a program operation to compensate for a lack of control gate bias.

Table No. 3 depicts typical voltage and current ranges that can be applied to the terminals of memory cell 410 for performing read, erase, and program operations:

**Table No. 3: Operation of Flash Memory Cell 410 of Figure 4**

| | WL/SG | BL | EG | SL |
|---|---|---|---|---|
| Read | 0.7-2.2V | 0.6-2V | 0-2.6V | 0V |
| Erase | -0.5V/0V | 0V | 11.5V | 0V |
| Program | 1V | 0.2-3µA | 4.5V | 7-9V |

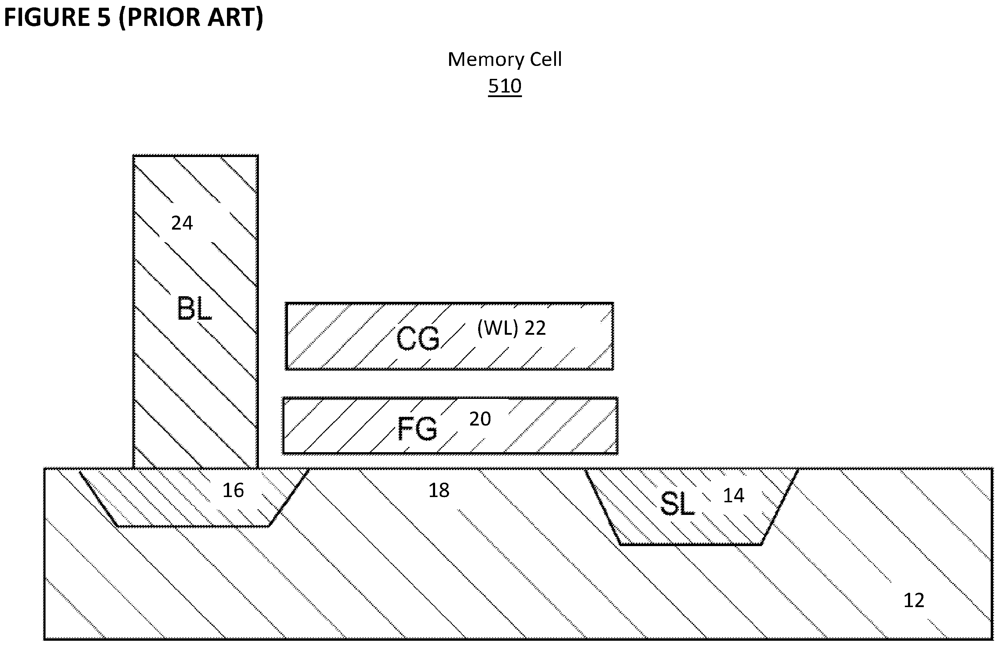

Figure 5 depicts stacked gate memory cell 510, which is another type of flash memory cell. Memory cell 510 is similar to memory cell 210 of Figure 2, except that floating gate 20 extends over the entire channel region 18, and control gate 22 (which here will be coupled to a word line) extends over floating gate 20, separated by an insulating layer (not shown). The erase is done by FN tunneling of electrons from FG to substrate, programming is by channel hot electron (CHE) injection at region between the channel 18 and the drain region 16, by the electrons flowing from the source region 14 towards to drain region 16 and read operation which is similar to that for memory cell 210 with a higher control gate voltage.

Table No. 4 depicts typical voltage ranges that can be applied to the terminals of memory cell 510 and substrate 12 for performing read, erase, and program operations:

**Table No. 4: Operation of Flash Memory Cell 510 of Figure 5**

| | CG | BL | SL | Substrate |
|---|---|---|---|---|
| Read | 2-5V | 0.6 - 2V | 0V | 0V |
| Erase | -8 to -10V/0V | FLT | FLT | 8-10V / 15-20V |
| Program | 8-12V | 3-5V | 0V | 0V |

The methods and means described herein may apply to other non-volatile memory technologies such as FINFET split gate flash or stack gate flash memory, NAND flash, SONOS (silicon-oxide-nitride-oxide-silicon, charge trap in nitride), MONOS (metal-oxide-nitride-oxide-silicon, metal charge trap in nitride), ReRAM (resistive ram), PCM (phase change memory), MRAM (magnetic ram), FeRAM (ferroelectric ram), CT (charge trap) memory, CN (carbon-tube) memory, OTP (bi-level or multi-level one time programmable), and CeRAM (correlated electron ram), without limitation.

In order to utilize the memory arrays comprising one of the types of non-volatile memory cells described above in an artificial neural network, two modifications are made. First, the lines are configured so that each memory cell can be individually programmed, erased, and read without adversely affecting the memory state of other memory cells in the array, as further explained below. Second, continuous (analog) programming of the memory cells is provided.

Specifically, the memory state (i.e., charge on the floating gate) of each memory cell in the array can be continuously changed from a fully erased state to a fully programmed state, and vice-versa, independently and with minimal disturbance of other memory cells. This means the cell storage is effectively analog or at the very least can store one of many discrete values (such as 16 or 64 different values), which allows for very precise and individual tuning of all the memory cells in the memory array, and which makes the memory array ideal for storing and making fine tuning adjustments to the synapsis weights of the neural network.

### Neural Networks Employing Non-Volatile Memory Cell Arrays

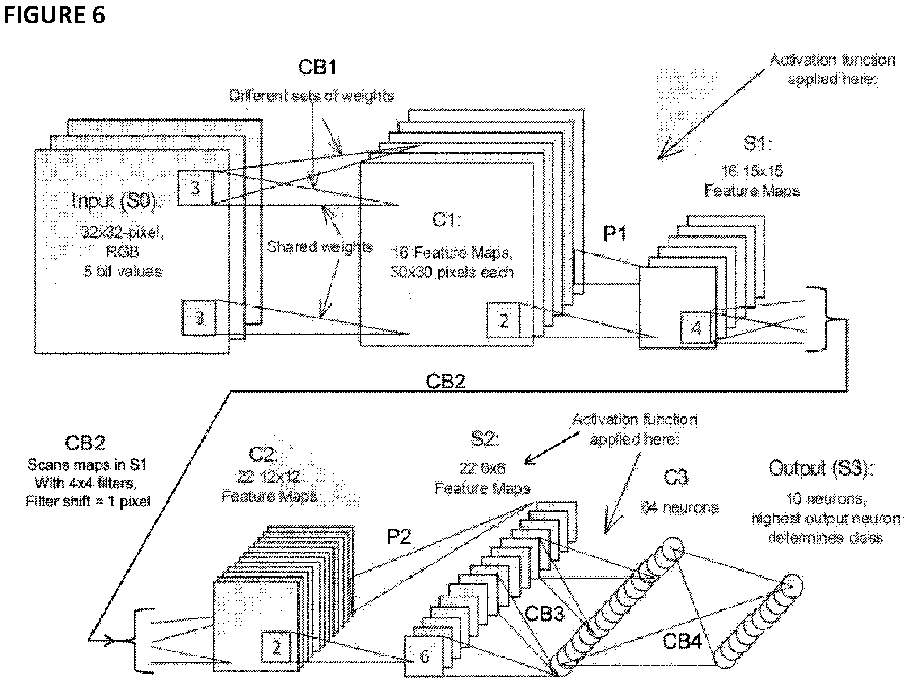

Figure 6 conceptually illustrates a non-limiting example of a neural network utilizing a non-volatile memory array of the present examples. This example uses the non-volatile memory array neural network for a facial recognition application, but any other appropriate application could be implemented using a non-volatile memory array based neural network.

S0 is the input layer, which for this example is a 32x32 pixel RGB image with 5 bit precision (i.e. three 32x32 pixel arrays, one for each color R, G and B, each pixel being 5 bit precision). The synapses CB1 going from input layer S0 to layer C1 apply different sets of weights in some instances and shared weights in other instances and scan the input image with 3x3 pixel overlapping filters (kernel), shifting the filter by 1 pixel (or more than 1 pixel as dictated by the model). Specifically, values for 9 pixels in a 3x3 portion of the image (i.e., referred to as a filter or kernel) are provided to the synapses CB1, where these 9 input values are multiplied by the appropriate weights and, after summing the outputs of that multiplication, a single output value is determined and provided by a first synapse of CB1 for generating a pixel of one of the feature maps of layer C1. The 3x3 filter is then shifted one pixel to the right within input layer S0 (i.e., adding the column of three pixels on the right, and dropping the column of three pixels on the left), whereby the 9 pixel values in this newly positioned filter are provided to the synapses CB1, where they are multiplied by the same weights and a second single output value is determined by the associated synapse. This process is continued until the 3x3 filter scans across the entire 32x32 pixel image of input layer S0, for all three colors and for all bits (precision values). The process is then repeated using different sets of weights to generate a different feature map of layer C1, until all the features maps of layer C1 have been calculated.

In layer C1, in the present example, there are 16 feature maps, with 30x30 pixels each. Each pixel is a new feature pixel extracted from multiplying the inputs and kernel, and therefore each feature map is a two dimensional array, and thus in this example layer C1 constitutes 16 layers of two dimensional arrays (keeping in mind that the layers and arrays referenced herein are logical relationships, not necessarily physical relationships - i.e., the arrays are not necessarily oriented in physical two dimensional arrays). Each of the 16 feature maps in layer C1 is generated by one of sixteen different sets of synapse weights applied to the filter scans. The C1 feature maps could all be directed to different aspects of the same image feature, such as boundary identification. For example, the first map (generated using a first weight set, shared for all scans used to generate this first map) could identify circular edges, the second map (generated using a second weight set different from the first weight set) could identify rectangular edges, or the aspect ratio of certain features, and so on.

An activation function P1 (pooling) is applied before going from layer C1 to layer S1, which pools values from consecutive, non-overlapping 2x2 regions in each feature map. The purpose of the pooling function P1 is to average out the nearby location (or a max function can also be used), to reduce the dependence of the edge location for example and to reduce the data size before going to the next stage. At layer S1, there are 16 15x15 feature maps (i.e., sixteen different arrays of 15x15 pixels each). The synapses CB2 going from layer S1 to layer C2 scan maps in layer S1 with 4x4 filters, with a filter shift of 1 pixel. At layer C2, there are 22 12x12 feature maps. An activation function P2 (pooling) is applied before going from layer C2 to layer S2, which pools values from consecutive non-overlapping 2x2 regions in each feature map. At layer S2, there are 22 6x6 feature maps. An activation function (pooling) is applied at the synapses CB3 going from layer S2 to layer C3, where every neuron in layer C3 connects to every map in layer S2 via a respective synapse of CB3. At layer C3, there are 64 neurons. The synapses CB4 going from layer C3 to the output layer S3 fully connects C3 to S3, i.e. every neuron in layer C3 is connected to every neuron in layer S3. The output at S3 includes 10 neurons, where the highest output neuron determines the class. This output could, for example, be indicative of an identification or classification of the contents of the original image.

Each layer of synapses is implemented using an array, or a portion of an array, of non-volatile memory cells.

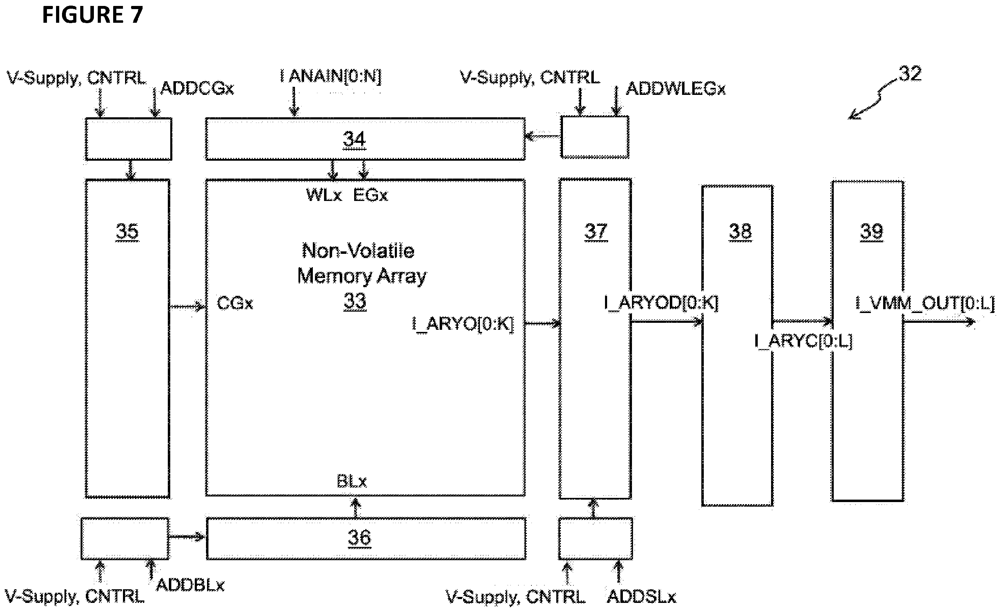

Figure 7 is a block diagram of an array that can be used for that purpose. Vector-by-matrix multiplication (VMM) array 32 includes non-volatile memory cells and is utilized as the synapses (such as CB1, CB2, CB3, and CB4 in Figure 6) between one layer and the next layer. Specifically, VMM array 32 includes an array of non-volatile memory cells 33, erase gate and word line gate decoder 34, control gate decoder 35, bit line decoder 36 and source line decoder 37, which decode the respective inputs for the non-volatile memory cell array 33. Input to VMM array 32 can be from the erase gate and wordline gate decoder 34 or from the control gate decoder 35. Source line decoder 37 in this example also decodes the output of the non-volatile memory cell array 33. Alternatively, bit line decoder 36 can decode the output of the non-volatile memory cell array 33.

Non-volatile memory cell array 33 serves two purposes. First, it stores the weights that will be used by the VMM array 32. Second, the non-volatile memory cell array 33 effectively multiplies the inputs by the weights stored in the non-volatile memory cell array 33 and adds them up per output line (source line or bit line) to produce the output, which will be the input to the next layer or input to the final layer. By performing the multiplication and addition function, the non-volatile memory cell array 33 negates the need for separate multiplication and addition logic circuits and is also power efficient due to its in-situ memory computation.

The output of non-volatile memory cell array 33 is supplied to a differential summer (such as a summing op-amp or a summing current mirror) 38, which sums up the outputs of the non-volatile memory cell array 33 to create a single value for that convolution. The differential summer 38 is arranged to perform summation of positive weight and negative weight.

The summed-up output values of differential summer 38 are then supplied to an activation function block 39, which rectifies the output. The activation function block 39 may provide sigmoid, tanh, or ReLU functions. The rectified output values of activation function block 39 become an element of a feature map as the next layer (e.g. C1 in Figure 6), and are then applied to the next synapse to produce the next feature map layer or final layer. Therefore, in this example, non-volatile memory cell array 33 constitutes a plurality of synapses (which receive their inputs from the prior layer of neurons or from an input layer such as an image database), and summing op-amp 38 and activation function block 39 constitute a plurality of neurons.

The input to VMM array 32 in Figure 7 (WLx, EGx, CGx, and optionally BLx and SLx) can be analog level, binary level, or digital bits (in which case a DAC is provided to convert digital bits to appropriate input analog level) and the output can be analog level, binary level, or digital bits (in which case an output ADC is provided to convert output analog level into digital bits).

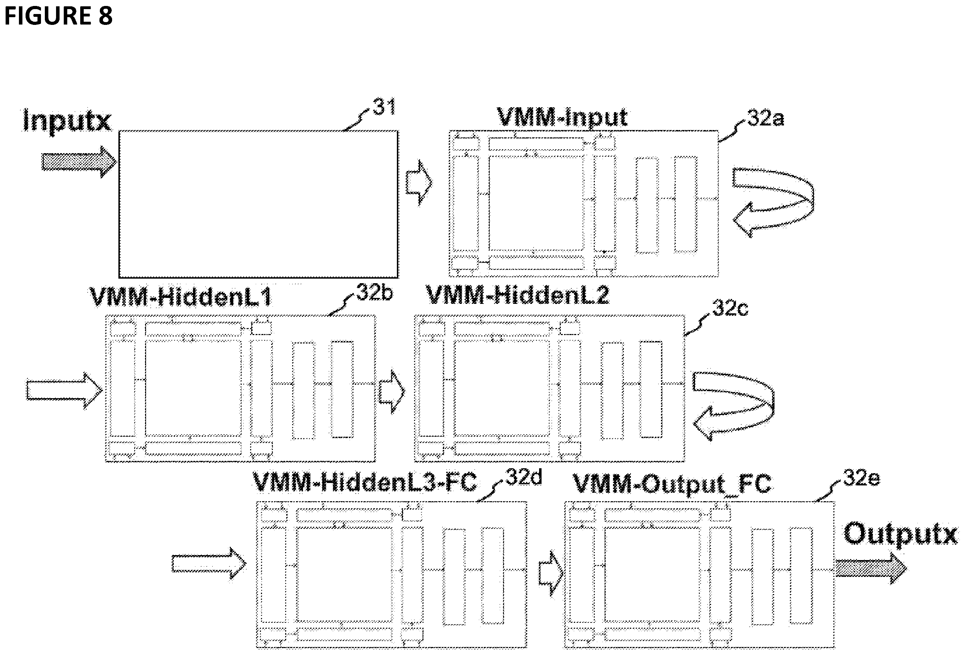

Figure 8 is a block diagram depicting the usage of numerous layers of VMM arrays 32, here labeled as VMM arrays 32a, 32b, 32c, 32d, and 32e. As shown in Figure 8, the input, denoted Inputx, is converted from digital to analog by a digital-to-analog converter 31 and provided to input VMM array 32a. The converted analog inputs could be voltage or current. The input D/A conversion for the first layer could be done by using a function or a LUT (look up table) that maps the inputs Inputx to appropriate analog levels for the matrix multiplier of input VMM array 32a. The input conversion could also be done by an analog to analog (A/A) converter to convert an external analog input to a mapped analog input to the input VMM array 32a.

The output generated by input VMM array 32a is provided as an input to the next VMM array (hidden level 1) 32b, which in turn generates an output that is provided as an input to the next VMM array (hidden level 2) 32c, and so on. The various layers of VMM array 32 function as different layers of synapses and neurons of a convolutional neural network (CNN). Each VMM array 32a, 32b, 32c, 32d, and 32e can be a stand-alone, physical non-volatile memory array, or multiple VMM arrays could utilize different portions of the same physical non-volatile memory array, or multiple VMM arrays could utilize overlapping portions of the same physical non-volatile memory array. The example shown in Figure 8 contains five layers (32a,32b,32c,32d,32e): one input layer (32a), two hidden layers (32b,32c), and two fully connected layers (32d,32e). One of ordinary skill in the art will appreciate that this is merely an example and that a system instead could comprise more than two hidden layers and more than two fully connected layers.

### Vector-by-Matrix Multiplication (VMM) Arrays

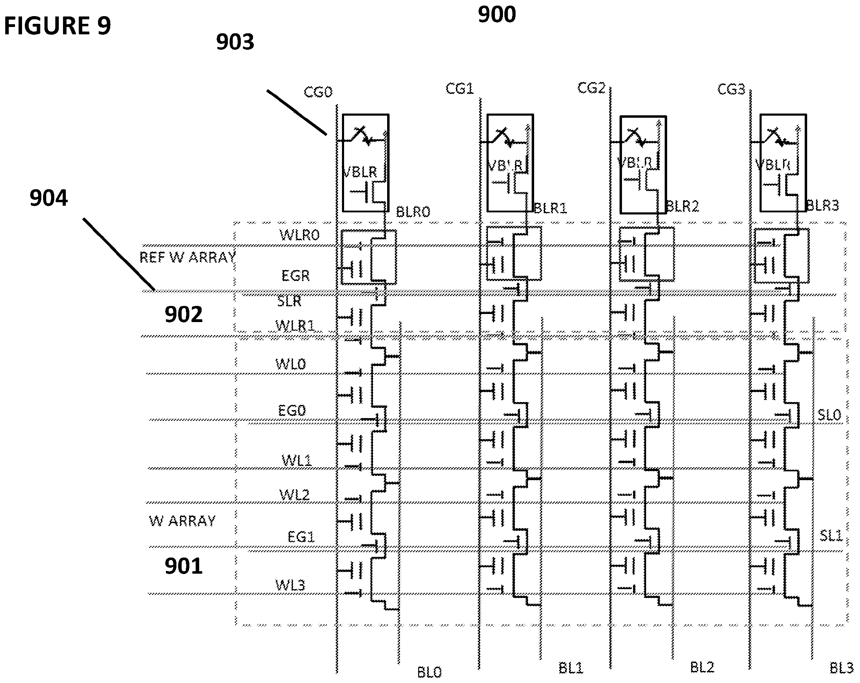

Figure 9 depicts neuron VMM array 900, which is particularly suited for memory cells 310 as shown in Figure 3 and is utilized as the synapses and parts of neurons between an input layer and the next layer. VMM array 900 comprises memory array 901 of non-volatile memory cells and reference array 902 (at the top of the array) of non-volatile reference memory cells. Alternatively, another reference array can be placed at the bottom.

In VMM array 900, control gate lines, such as control gate line 903, run in a vertical direction (hence reference array 902 in the row direction is orthogonal to control gate line 903), and erase gate lines, such as erase gate line 904, run in a horizontal direction. Here, the inputs to VMM array 900 are provided on the control gate lines (CGO, CG1, CG2, CG3), and the output of VMM array 900 emerges on the source lines (SLO, SL1). In one example, only even rows are used, and in another example, only odd rows are used. The current placed on each source line (SLO, SL1, respectively) performs a summing function of all the currents from the memory cells connected to that particular source line.

As described herein for neural networks, the non-volatile memory cells of VMM array 900, i.e., the memory cells 310 of VMM array 900, may be configured to operate in a sub-threshold region.

The non-volatile reference memory cells and the non-volatile memory cells described herein are biased in weak inversion (sub threshold region): $Ids = Io * {e}^{\left(Vg-Vth\right) / nVt} = w * Io * {e}^{\left(Vg\right) / nVt} ,$ where w = e ^{(- Vth)/nVt}
where Ids is the drain to source current; Vg is gate voltage on the memory cell; Vth is threshold voltage of the memory cell; Vt is thermal voltage = k*T/q with k being the Boltzmann constant, T the temperature in Kelvin, and q the electronic charge; n is a slope factor = 1 + (Cdep/Cox) with Cdep = capacitance of the depletion layer, and Cox capacitance of the gate oxide layer; Io is the memory cell current at gate voltage equal to threshold voltage, Io is proportional to (Wt/L)*u*Cox* (n-1) * Vt² where u is carrier mobility and Wt and L are width and length, respectively, of the memory cell.

For an I-to-V log converter using a memory cell (such as a reference memory cell or a peripheral memory cell) or a transistor to convert input current into an input voltage: $Vg = n * Vt * log \left[Ids/wp*Io\right]$ where, wp is w of a reference or peripheral memory cell.

For a memory array used as a vector matrix multiplier VMM array with the current input, the output current is: $Iout = wa * Io * {e}^{\left(Vg\right) / nVt} ,$ namely $Iout = \left(wa/wp\right) * Iin = W * Iin$ $W = {e}^{\left(Vthp-Vtha\right) / nVt}$ Here, wa = w of each memory cell in the memory array.
Vthp is effective threshold voltage of the peripheral memory cell and Vtha is effective threshold voltage of the main (data) memory cell. Note that the threshold voltage of a transistor is a function of substrate body bias voltage and the substrate body bias voltage, denoted Vsb, can be modulated to compensate for various conditions, on such temperature. The threshold voltage Vth can be expressed as: $Vth = Vth 0 + gamma \left(\left.SQRT\right|Vsb-2* φF\right) - SQRT \left|2* φF\right|$ where Vth0 is threshold voltage with zero substrate bias, φF is a surface potential, and gamma is a body effect parameter.

A wordline or control gate can be used as the input for the memory cell for the input voltage.

Alternatively, the flash memory cells of VMM arrays described herein can be configured to operate in the linear region: $Ids = beta * \left(Vgs-Vth\right) * Vds ; beta = u * Cox * Wt / L$ $W = α \left(Vgs-Vth\right)$ meaning weight W in the linear region is proportional to (Vgs-Vth)

A wordline or control gate or bitline or sourceline can be used as the input for the memory cell operated in the linear region. The bitline or sourceline can be used as the output for the memory cell.

For an I-to-V linear converter, a memory cell (such as a reference memory cell or a peripheral memory cell) or a transistor operating in the linear region can be used to linearly convert an input/output current into an input/output voltage.

Alternatively, the memory cells of VMM arrays described herein can be configured to operate in the saturation region: $Ids = \frac{1}{2} * beta * {\left(Vgs-Vth\right)}^{2} ; beta = u * Cox * Wt / L$ Wα (Vgs-Vth)², meaning weight W is proportional to (Vgs-Vth)²

A wordline, control gate, or erase gate can be used as the input for the memory cell operated in the saturation region. The bitline or sourceline can be used as the output for the output neuron.

Alternatively, the memory cells of VMM arrays described herein can be used in all regions or a combination thereof (sub threshold, linear, or saturation) for each layer or multi layers of a neural network.

Other examples for VMM array 32 of Figure 7 are described in U.S. Patent No. 10,748,630, which is incorporated by reference herein. As described in that application. a sourceline or a bitline can be used as the neuron output (current summation output).

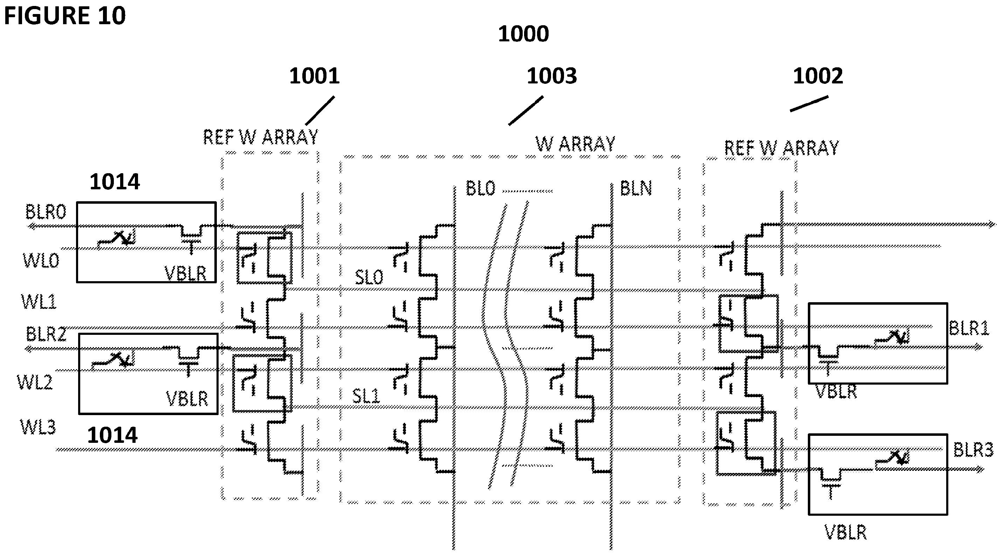

Figure 10 depicts neuron VMM array 1000, which is particularly suited for memory cells 210 as shown in Figure 2 and is utilized as the synapses between an input layer and the next layer. VMM array 1000 comprises a memory array 1003 of non-volatile memory cells, reference array 1001 of first non-volatile reference memory cells, and reference array 1002 of second non-volatile reference memory cells. Reference arrays 1001 and 1002, arranged in the column direction of the array, serve to convert current inputs flowing into terminals BLR0, BLR1, BLR2, and BLR3 into voltage inputs WL0, WL1, WL2, and WL3. In effect, the first and second non-volatile reference memory cells are diode-connected through multiplexors 1014 (only partially depicted) with current inputs flowing into them. The reference cells are tuned (e.g., programmed) to target reference levels. The target reference levels are provided by a reference mini-array matrix (not shown).

Memory array 1003 serves two purposes. First, it stores the weights that will be used by the VMM array 1000 on respective memory cells thereof. Second, memory array 1003 effectively multiplies the inputs (i.e. current inputs provided in terminals BLR0, BLR1, BLR2, and BLR3, which reference arrays 1001 and 1002 convert into the input voltages to supply to wordlines WL0, WL1, WL2, and WL3) by the weights stored in the memory array 1003 and then adds all the results (memory cell currents) to produce the output on the respective bit lines (BL0 - BLN), which will be the input to the next layer or input to the final layer. By performing the multiplication and addition function, memory array 1003 negates the need for separate multiplication and addition logic circuits and is also power efficient. Here, the voltage inputs are provided on the word lines WL0, WL1, WL2, and WL3, and the output emerges on the respective bit lines BL0 - BLN during a read (inference) operation. The current placed on each of the bit lines BL0 - BLN performs a summing function of the currents from all non-volatile memory cells connected to that particular bitline.

Table No. 5 depicts operating voltages and currents for VMM array 1000. The columns in the table indicate the voltages placed on word lines for selected cells, word lines for unselected cells, bit lines for selected cells, bit lines for unselected cells, source lines for selected cells, and source lines for unselected cells. The rows indicate the operations of read, erase, and program.

**Table No. 5: Operation of VMM Array 1000 of Figure 10:**

| | **WL** | **WL -unsel** | **BL** | **BL -unsel** | **SL** | **SL -unsel** |
|---|---|---|---|---|---|---|
| **Read** | 1-3.5V | -0.5V/0V | 0.6-2V (Ineuron) | 0.6V-2V/0V | 0V | 0V |
| **Erase** | ~5-13V | 0V | 0V | 0V | 0V | 0V |
| **Program** | 1-2V | -0.5V/0V | 0.1-3 uA | Vinh ~2.5V | 4-10V | 0-1V/FLT |

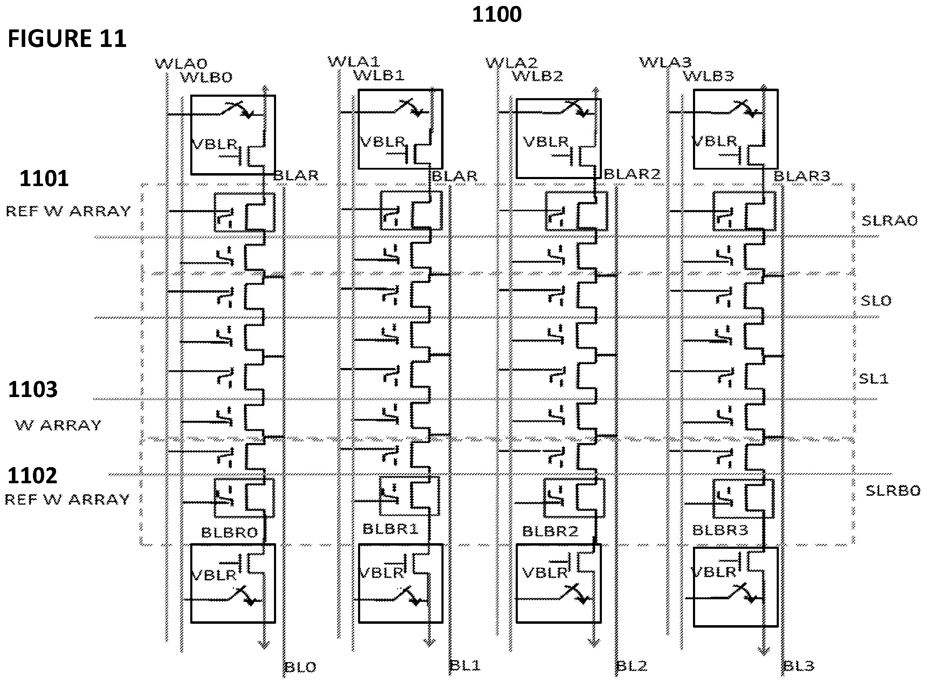

Figure 11 depicts neuron VMM array 1100, which is particularly suited for memory cells 210 as shown in Figure 2 and is utilized as the synapses and parts of neurons between an input layer and the next layer. VMM array 1100 comprises a memory array 1103 of non-volatile memory cells, reference array 1101 of first non-volatile reference memory cells, and reference array 1102 of second non-volatile reference memory cells. Reference arrays 1101 and 1102 run in row direction of the VMM array 1100. VMM array is similar to VMM 1000 except that in VMM array 1100, the word lines run in the vertical direction. Here, the inputs are provided on the word lines (WLA0, WLB0, WLA1, WLB2, WLA2, WLB2, WLA3, WLB3), and the output emerges on the source line (SLO, SL1) during a read operation. The current placed on each source line performs a summing function of all the currents from the memory cells connected to that particular source line.

Table No. 6 depicts operating voltages and currents for VMM array 1100. The columns in the table indicate the voltages placed on word lines for selected cells, word lines for unselected cells, bit lines for selected cells, bit lines for unselected cells, source lines for selected cells, and source lines for unselected cells. The rows indicate the operations of read, erase, and program.

**Table No. 6: Operation of VMM Array 1100 of Figure 11**

| | WL | WL -unsel | BL | BL -unsel | SL | SL -unsel |
|---|---|---|---|---|---|---|
| **Read** | 1-3.5V | -0.5V/0V | 0.6-2V | 0.6V-2V/0V | ~0.3-1V (Ineuron) | 0V |
| **Erase** | ~5-13V | 0V | 0V | 0V | 0V | SL-inhibit (~4-8V) |
| **Program** | 1-2V | -0.5V/0V | 0.1-3 uA | Vinh ~2.5V | 4-10V | 0-1V/FLT |

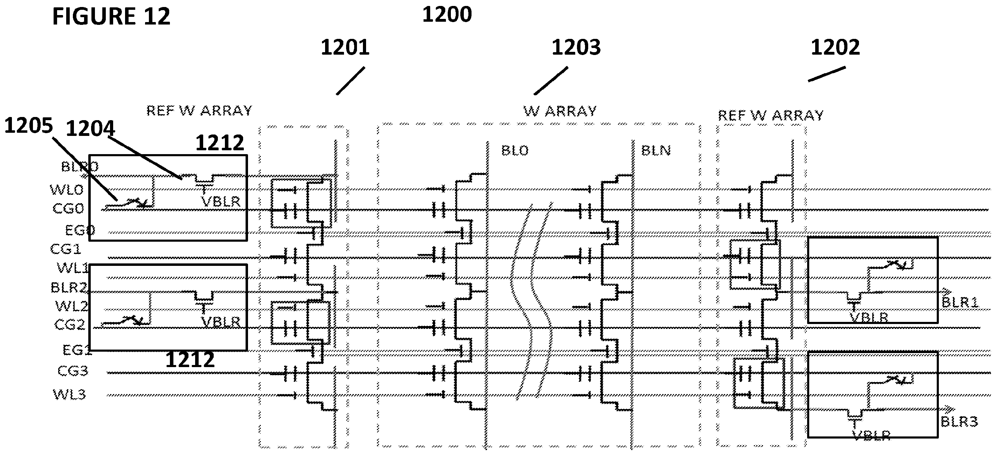

Figure 12 depicts neuron VMM array 1200, which is particularly suited for memory cells 310 as shown in Figure 3 and is utilized as the synapses and parts of neurons between an input layer and the next layer. VMM array 1200 comprises a memory array 1203 of non-volatile memory cells, reference array 1201 of first non-volatile reference memory cells, and reference array 1202 of second non-volatile reference memory cells. Reference arrays 1201 and 1202 serve to convert current inputs flowing into terminals BLR0, BLR1, BLR2, and BLR3 into voltage inputs CG0, CG1, CG2, and CG3. In effect, the first and second non-volatile reference memory cells are diode-connected through multiplexors 1212 (only partially shown) with current inputs flowing into them through BLR0, BLR1, BLR2, and BLR3. Multiplexors 1212 each include a respective multiplexor 1205 and a cascoding transistor 1204 to ensure a constant voltage on the bitline (such as BLR0) of each of the first and second non-volatile reference memory cells during a read operation. The reference cells are tuned to target reference levels.

Memory array 1203 serves two purposes. First, it stores the weights that will be used by the VMM array 1200. Second, memory array 1203 effectively multiplies the inputs (current inputs provided to terminals BLR0, BLR1, BLR2, and BLR3, for which reference arrays 1201 and 1202 convert these current inputs into the input voltages to supply to the control gates (CGO, CG1, CG2, and CG3) by the weights stored in the memory array and then add all the results (cell currents) to produce the output, which appears on BL0 - BLN, and will be the input to the next layer or input to the final layer. By performing the multiplication and addition function, the memory array negates the need for separate multiplication and addition logic circuits and is also power efficient. Here, the inputs are provided on the control gate lines (CGO, CG1, CG2, and CG3), and the output emerges on the bit lines (BL0 - BLN) during a read operation. The current placed on each bitline performs a summing function of all the currents from the memory cells connected to that particular bitline.

VMM array 1200 implements uni-directional tuning for non-volatile memory cells in memory array 1203. That is, each non-volatile memory cell is erased and then partially programmed until the desired charge on the floating gate is reached. If too much charge is placed on the floating gate (such that the wrong value is stored in the cell), the cell is erased and the sequence of partial programming operations starts over. As shown, two rows sharing the same erase gate (such as EG0 or EG1) are erased together (which is known as a page erase), and thereafter, each cell is partially programmed until the desired charge on the floating gate is reached.

Table No. 7 depicts operating voltages and currents for VMM array 1200. The columns in the table indicate the voltages placed on word lines for selected cells, word lines for unselected cells, bit lines for selected cells, bit lines for unselected cells, control gates for selected cells, control gates for unselected cells in the same sector as the selected cells, control gates for unselected cells in a different sector than the selected cells, erase gates for selected cells, erase gates for unselected cells, source lines for selected cells, and source lines for unselected cells. The rows indicate the operations of read, erase, and program.

**Table No. 7: Operation of VMM Array 1200 of Figure 12**

| | **WL** | **WL - unsel** | **BL** | **BL - unsel** | **CG** | **CG-unsel same sector** | **CG - unsel** | **EG** | **EG** - **unsel** | **SL** | **SL** - **unsel** |
|---|---|---|---|---|---|---|---|---|---|---|---|
| **Read** | 1.0-2V | -0.5V/ 0V | 0.6-2V (Ineuron) | 0V | 0-2.6V | 0-2.6V | 0-2.6V | 0-2.6V | 0-2.6V | 0V | 0V |
| **Erase** | 0V | 0V | 0V | 0V | 0V | 0-2.6V | 0-2.6V | 5-12V | 0-2.6V | 0V | 0V |
| **Program** | 0.7-1V | -0.5V/ 0V | 0.1-1uA | Vinh (1-2V) | 4-11V | 0-2.6V | 0-2.6V | 4.5-5V | 0-2.6V | 4.5-5V | 0-1V |

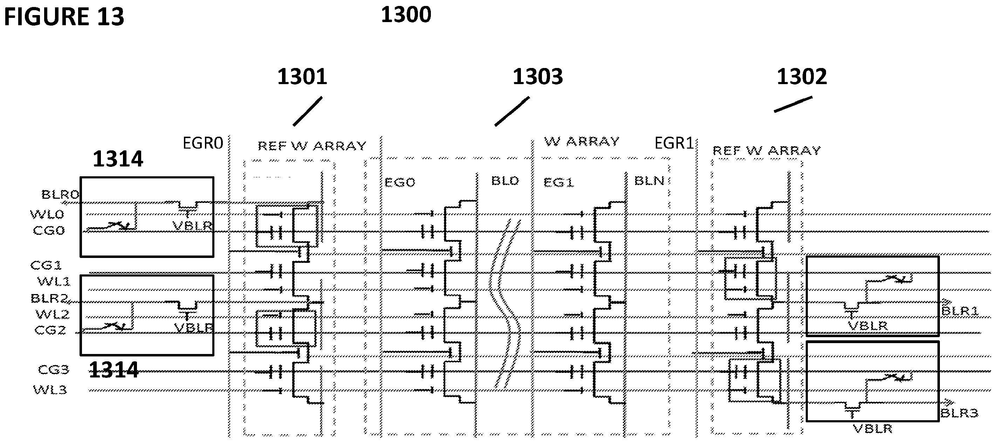

Figure 13 depicts neuron VMM array 1300, which is particularly suited for memory cells 310 as shown in Figure 3, and is utilized as the synapses and parts of neurons between an input layer and the next layer. VMM array 1300 comprises a memory array 1303 of non-volatile memory cells, reference array 1301 or first non-volatile reference memory cells, and reference array 1302 of second non-volatile reference memory cells. EG lines EGR0, EG0, EG1 and EGR1 are run vertically while CG lines CG0, CG1, CG2 and CG3 and SL lines WL0, WL1, WL2 and WL3 are run horizontally. VMM array 1300 is similar to VMM array 1400, except that VMM array 1300 implements bi-directional tuning, where each individual cell can be completely erased, partially programmed, and partially erased as needed to reach the desired amount of charge on the floating gate due to the use of separate EG lines. As shown, reference arrays 1301 and 1302 convert input current in the terminal BLR0, BLR1, BLR2, and BLR3 into control gate voltages CG0, CG1, CG2, and CG3 (through the action of diode-connected reference cells through multiplexors 1314) to be applied to the memory cells in the row direction. The current output (neuron) is in the bit lines BL0 - BLN, where each bit line sums all currents from the non-volatile memory cells connected to that particular bitline.

Table No. 8 depicts operating voltages and currents for VMM array 1300. The columns in the table indicate the voltages placed on word lines for selected cells, word lines for unselected cells, bit lines for selected cells, bit lines for unselected cells, control gates for selected cells, control gates for unselected cells in the same sector as the selected cells, control gates for unselected cells in a different sector than the selected cells, erase gates for selected cells, erase gates for unselected cells, source lines for selected cells, and source lines for unselected cells. The rows indicate the operations of read, erase, and program.

**Table No. 8: Operation of VMM Array 1300 of Figure 13**

| | **WL** | **WL** - **unsel** | **BL** | **BL** - **unsel** | **CG** | **CG -unsel same sector** | **CG - unsel** | **EG** | **EG - unsel** | **SL** | **SL** - **unsel** |
|---|---|---|---|---|---|---|---|---|---|---|---|
| **Read** | 1.0-2V | -0.5V/ 0V | 0.6-2V (Ineuron) | 0V | 0-2.6V | 0-2.6V | 0-2.6V | 0-2.6V | 0-2.6V | 0V | 0V |
| **Erase** | 0V | 0V | 0V | 0V | 0V | 4-9V | 0-2.6V | 5-12V | 0-2.6V | 0V | 0V |
| **Program** | 0.7-1V | -0.5V/ 0V | 0.1-1uA | Vinh (1-2V) | 4-11V | 0-2.6V | 0-2.6V | 4.5-5V | 0-2.6V | 4.5-5V | 0-1V |

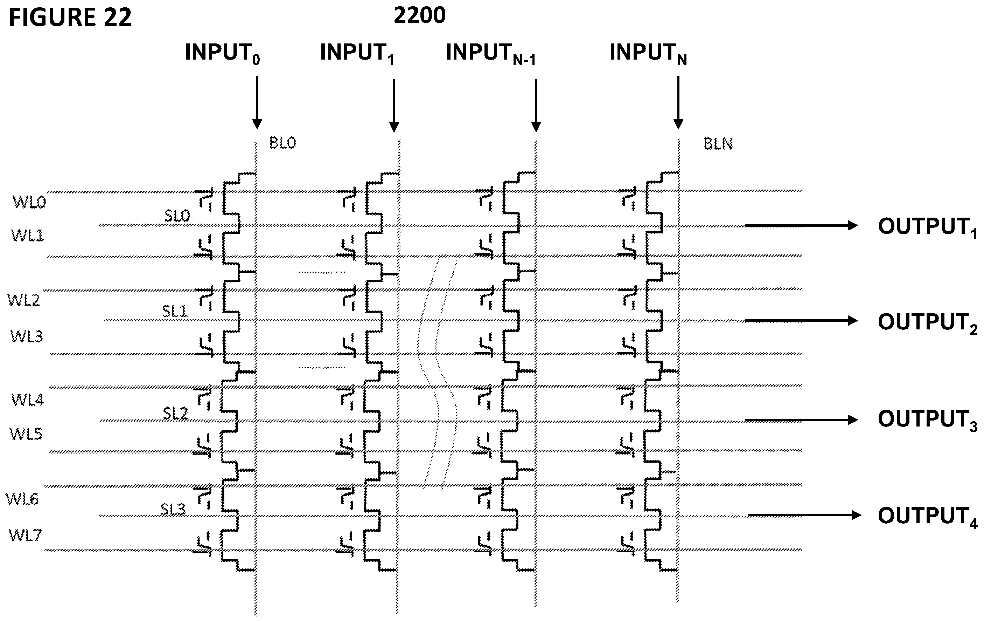

Figure 22 depicts neuron VMM array 2200, which is particularly suited for memory cells 210 as shown in Figure 2 and is utilized as the synapses and parts of neurons between an input layer and the next layer. In VMM array 2200, the inputs INPUT₀. ..., INPUT_{N} are received on bit lines BL₀, . . . BL_{N}, respectively, and the outputs OUTPUT₁, OUTPUT₂, OUTPUT₃, and OUTPUT₄ are generated on source lines SL₀, SL₁, SL₂, and SL₃, respectively.

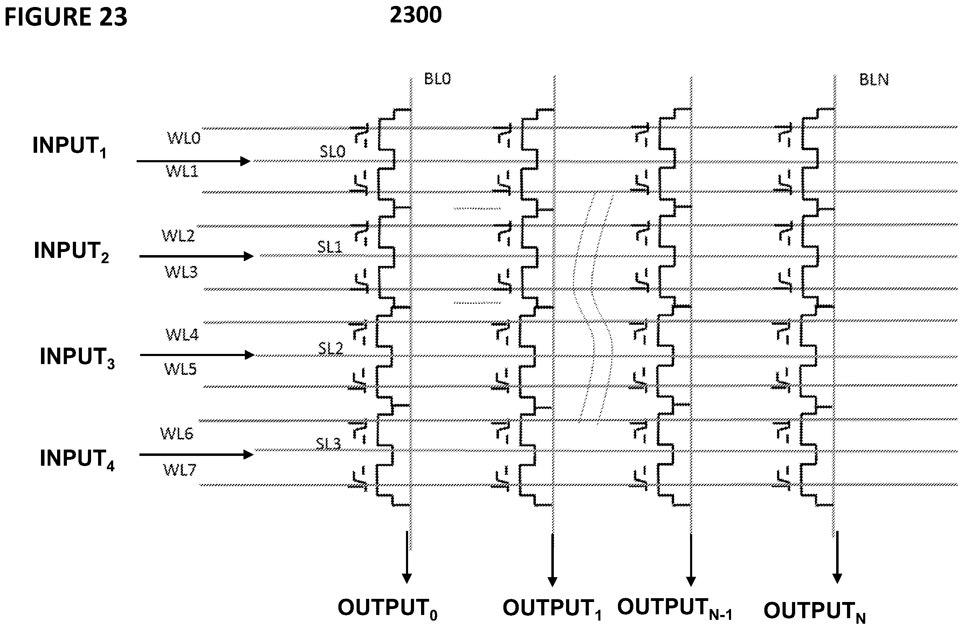

Figure 23 depicts neuron VMM array 2300, which is particularly suited for memory cells 210 as shown in Figure 2 and is utilized as the synapses and parts of neurons between an input layer and the next layer. In this example, the inputs INPUT₀ INPUT₁, INPUT₂, and INPUT₃ are received on source lines SL₀, SL₁, SL₂, and SL₃, respectively, and the outputs OUTPUT₀, . . . OUTPUT_{N} are generated on bit lines BL₀, ..., BL_{N}.

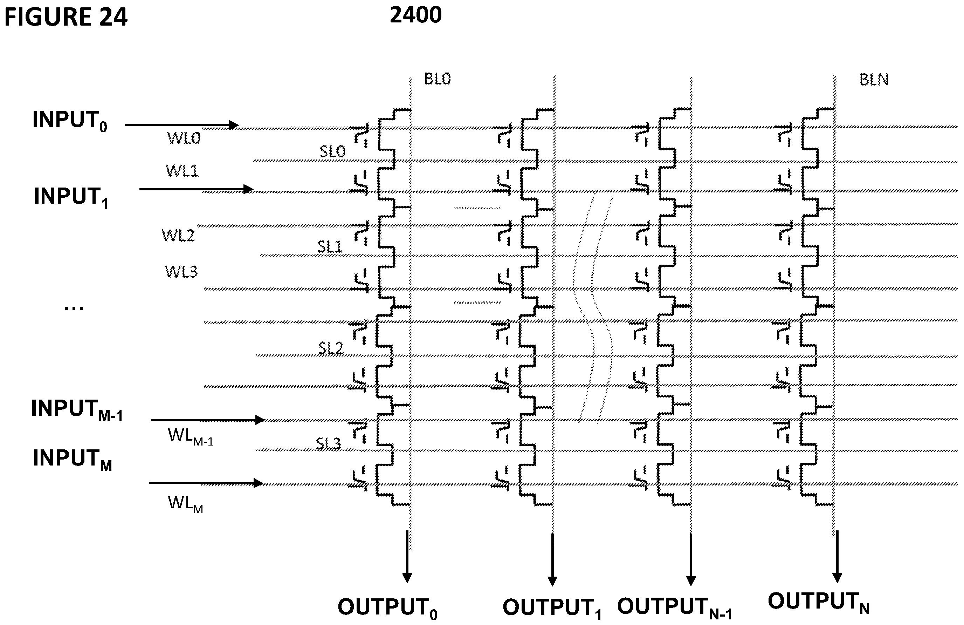

Figure 24 depicts neuron VMM array 2400, which is particularly suited for memory cells 210 as shown in Figure 2, and is utilized as the synapses and parts of neurons between an input layer and the next layer. In this example, the inputs INPUT₀, ..., INPUT_{M} are received on word lines WL₀, ..., WL_{M}, respectively, and the outputs OUTPUT₀, . . . OUTPUT_{N} are generated on bit lines BL₀, ..., BL_{N}.

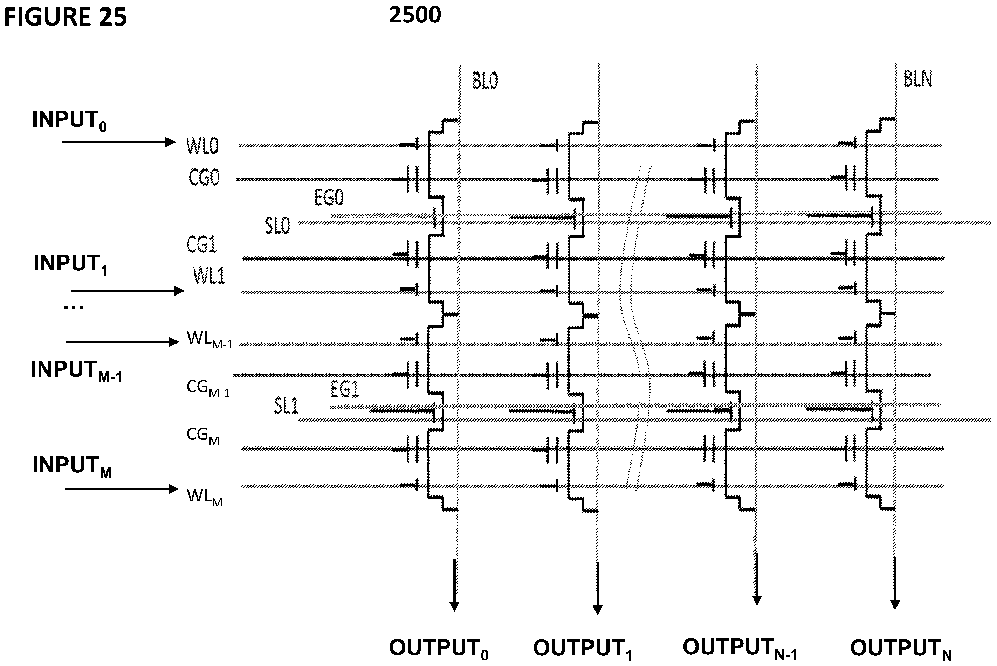

Figure 25 depicts neuron VMM array 2500, which is particularly suited for memory cells 310 as shown in Figure 3, and is utilized as the synapses and parts of neurons between an input layer and the next layer. In this example, the inputs INPUT₀ ..., INPUT_{M} are received on word lines WL₀, ..., WL_{M}, respectively, and the outputs OUTPUT₀, . . . OUTPUT_{N} are generated on bit lines BL₀, ..., BL_{N}.

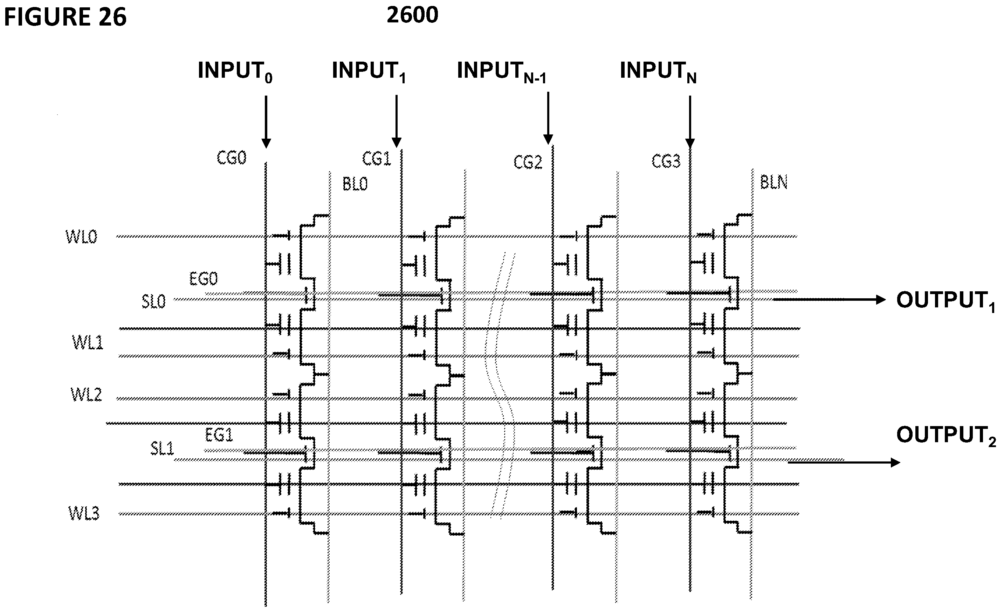

Figure 26 depicts neuron VMM array 2600, which is particularly suited for memory cells 410 as shown in Figure 4, and is utilized as the synapses and parts of neurons between an input layer and the next layer. In this example, the inputs INPUT₀ ..., INPUTₙ are received on vertical control gate lines CG₀, ..., CG_{N}, respectively, and the outputs OUTPUT₁ and OUTPUT₂ are generated on source lines SL₀ and SL₁.

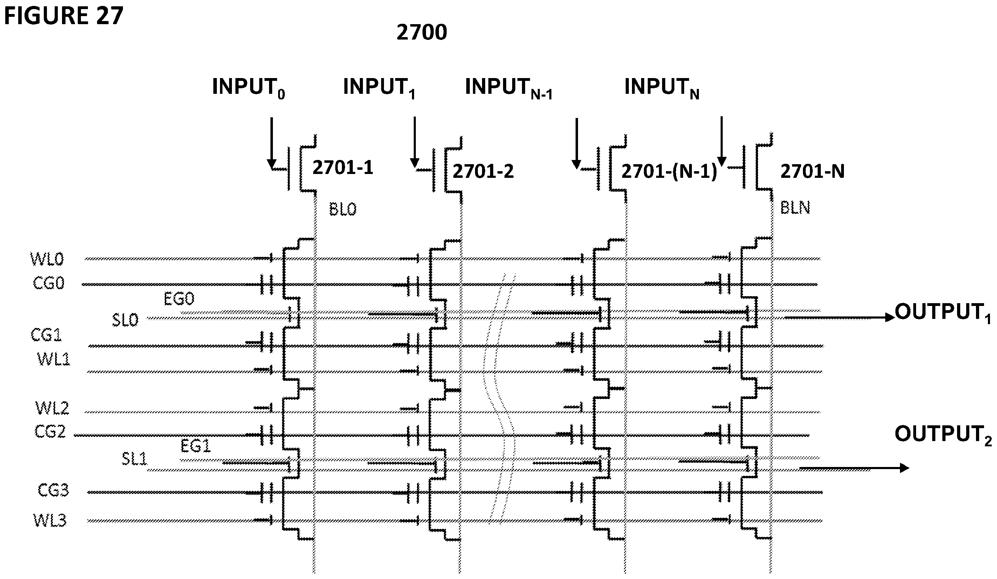

Figure 27 depicts neuron VMM array 2700, which is particularly suited for memory cells 410 as shown in Figure 4 and is utilized as the synapses and parts of neurons between an input layer and the next layer. In this example, the inputs INPUT₀ ..., INPUT_{N} are received on the gates of bit line control gates 2701-1, 2701-2, ..., 2701-(N-1), and 2701-N, respectively, which are coupled to bit lines BL₀, ..., BL_{N}, respectively. Example outputs OUTPUT₁ and OUTPUT₂ are generated on source lines SL₀ and SL₁.

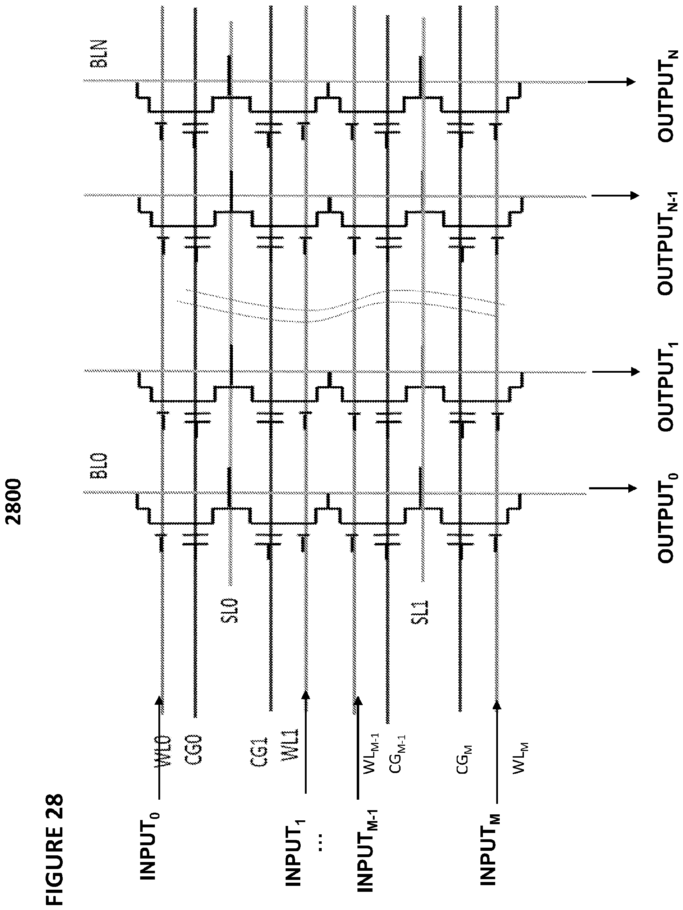

Figure 28 depicts neuron VMM array 2800, which is particularly suited for memory cells 310 as shown in Figure 3, memory cells 510 as shown in Figure 5, and memory cells 710 as shown in Figure 7, and is utilized as the synapses and parts of neurons between an input layer and the next layer. In this example, the inputs INPUT₀, ..., INPUT_{M} are received on word lines WL₀, ..., WL_{M}, and the outputs OUTPUT₀, ..., OUTPUT_{N} are generated on bit lines BL₀, ..., BL_{N}, respectively.

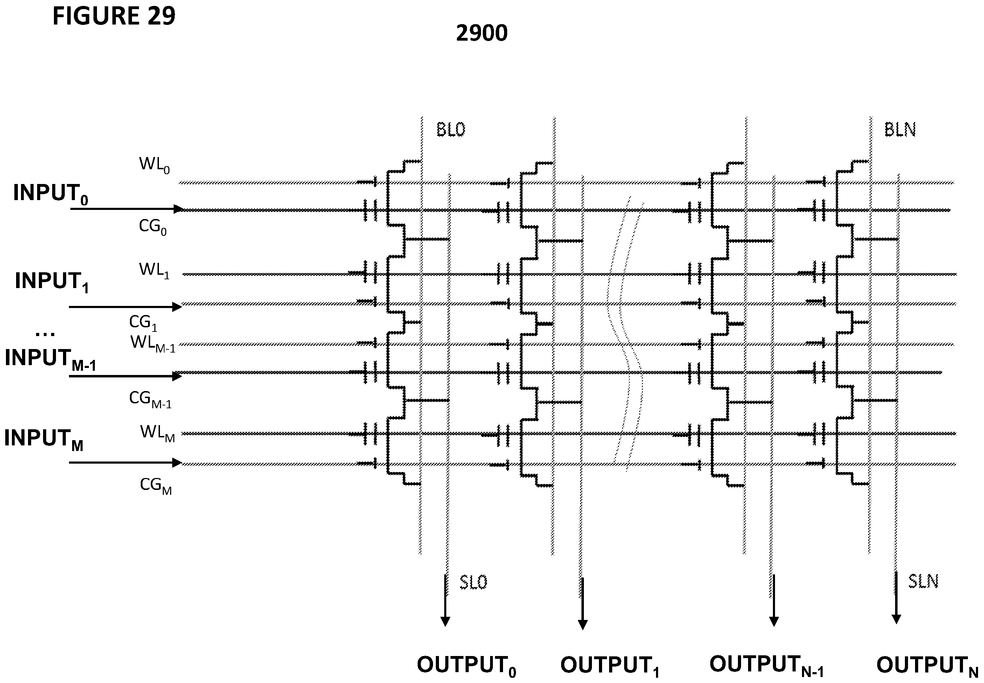

Figure 29 depicts neuron VMM array 2900, which is particularly suited for memory cells 310 as shown in Figure 3, memory cells 510 as shown in Figure 5, and memory cells 710 as shown in Figure 7, and is utilized as the synapses and parts of neurons between an input layer and the next layer. In this example, the inputs INPUT₀ ..., INPUT_{M} are received on control gate lines CG₀, ..., CG_{M}. Outputs OUTPUT₀, ..., OUTPUT_{N} are generated on vertical source lines SL₀, ..., SL_{N}, respectively, where each source line SLᵢ is coupled to the source lines of all memory cells in column i.

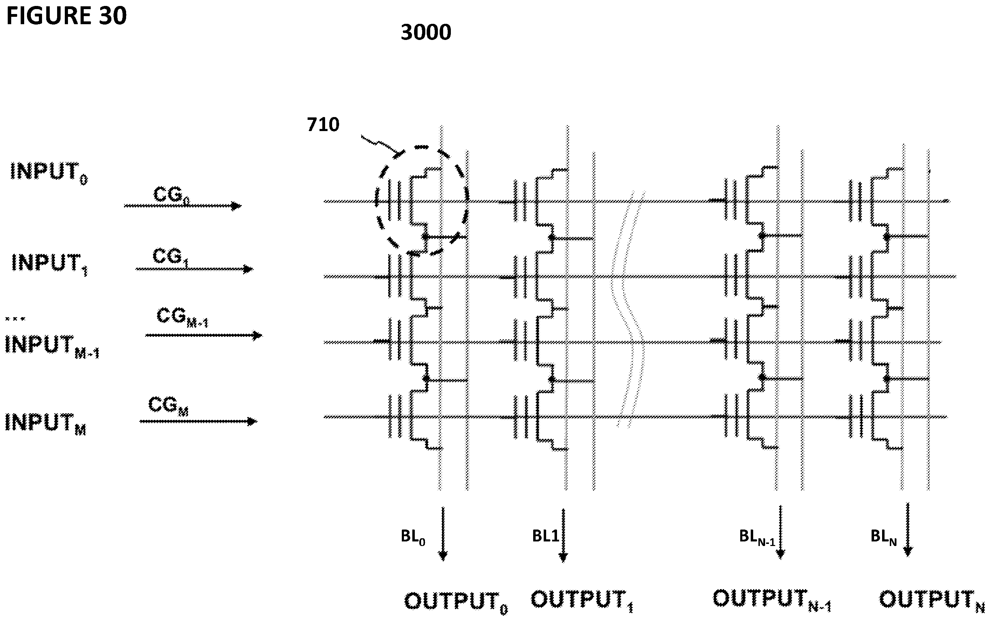

Figure 30 depicts neuron VMM array 3000, which is particularly suited for memory cells 310 as shown in Figure 3, memory cells 510 as shown in Figure 5, and memory cells 710 as shown in Figure 7, and is utilized as the synapses and parts of neurons between an input layer and the next layer. In this example, the inputs INPUT₀ ..., INPUT_{M} are received on control gate lines CG₀, ..., CG_{M}. Outputs OUTPUT₀, ..., OUTPUT_{N} are generated on vertical bit lines BL₀, ..., BL_{N}, respectively, where each bit line BLᵢ is coupled to the bit lines of all memory cells in column i.

### Long Short-Term Memory

The prior art includes a concept known as long short-term memory (LSTM). LSTM units often are used in neural networks. LSTM allows a neural network to remember information over predetermined arbitrary time intervals and to use that information in subsequent operations. A conventional LSTM unit comprises a cell, an input gate, an output gate, and a forget gate. The three gates regulate the flow of information into and out of the cell and the time interval that the information is remembered in the LSTM. VMMs are particularly useful in LSTM units.

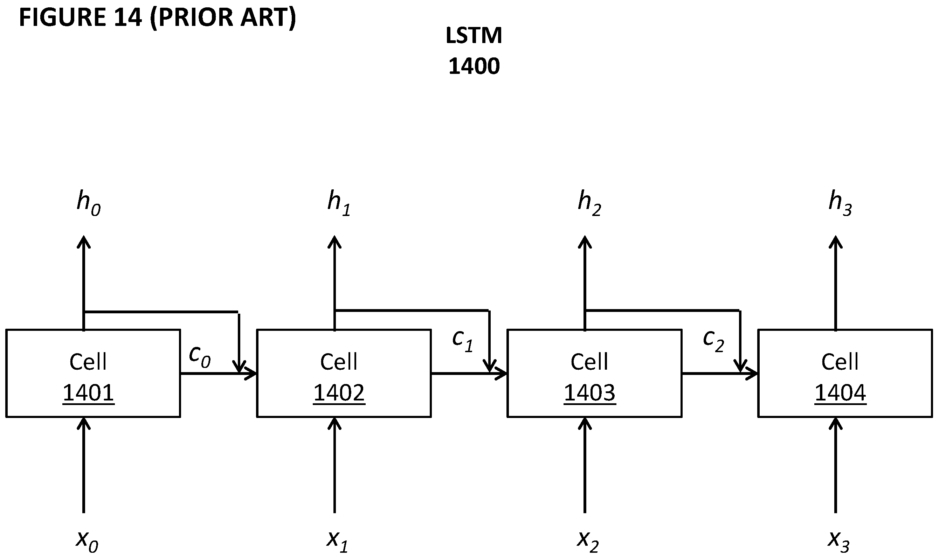

Figure 14 depicts an example LSTM 1400. LSTM 1400 in this example comprises cells 1401, 1402, 1403, and 1404. Cell 1401 receives input vector x₀ and generates output vector h₀ and cell state vector c₀. Cell 1402 receives input vector x₁, the output vector (hidden state) h₀ from cell 1401, and cell state c₀ from cell 1401 and generates output vector h₁ and cell state vector c₁. Cell 1403 receives input vector x₂, the output vector (hidden state) h₁ from cell 1402, and cell state c₁ from cell 1402 and generates output vector h₂ and cell state vector c₂. Cell 1404 receives input vector x₃, the output vector (hidden state) h₂ from cell 1403, and cell state c₂ from cell 1403 and generates output vector h₃. Additional cells can be used, and an LSTM with four cells is merely an example.

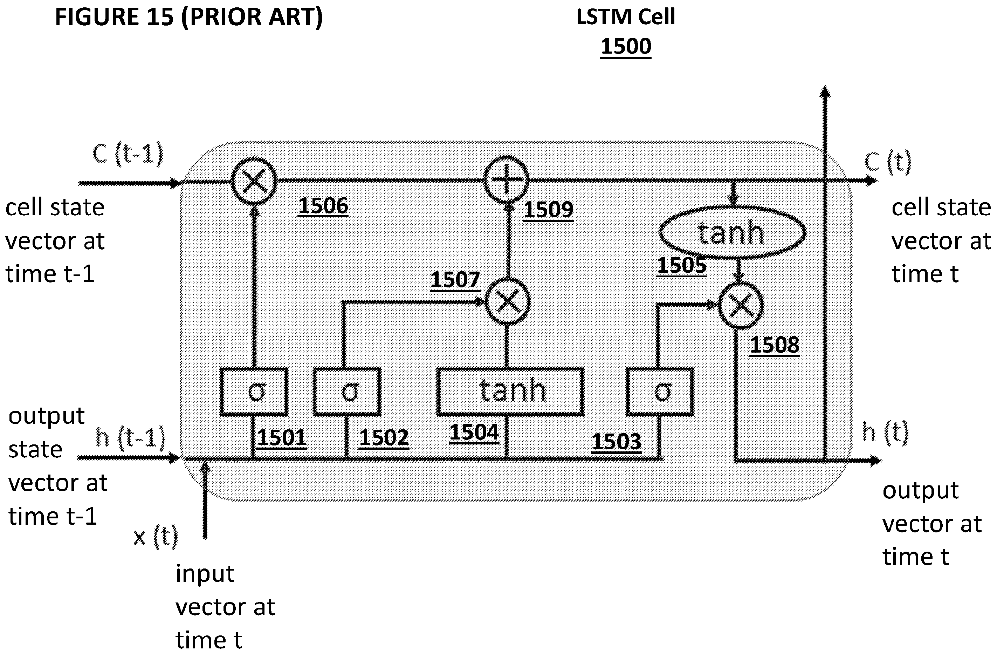

Figure 15 depicts an example implementation of an LSTM cell 1500, which can be used for cells 1401, 1402, 1403, and 1404 in Figure 14. LSTM cell 1500 receives input vector x(t), cell state vector c(t-1) from a preceding cell, and output vector h(t-1) from a preceding cell, and generates cell state vector c(t) and output vector h(t).

LSTM cell 1500 comprises sigmoid function devices 1501, 1502, and 1503, each of which applies a number between 0 and 1 to control how much of each component in the input vector is allowed through to the output vector. LSTM cell 1500 also comprises tanh devices 1504 and 1505 to apply a hyperbolic tangent function to an input vector, multiplier devices 1506, 1507, and 1508 to multiply two vectors together, and addition device 1509 to add two vectors together. Output vector h(t) can be provided to the next LSTM cell in the system, or it can be accessed for other purposes.

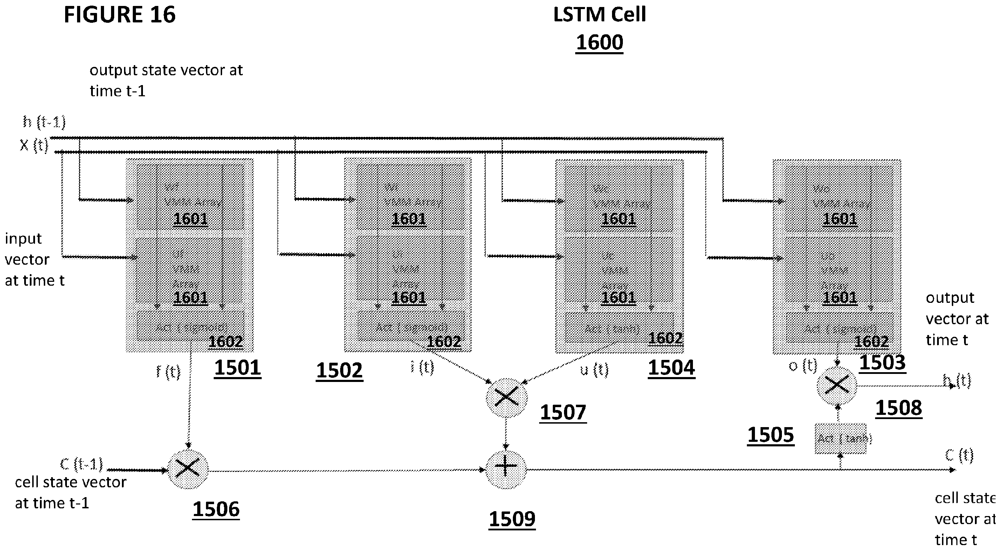

Figure 16 depicts an LSTM cell 1600, which is an example of an implementation of LSTM cell 1500. For the reader's convenience, the same numbering from LSTM cell 1500 is used in LSTM cell 1600. Sigmoid function devices 1501, 1502, and 1503 and tanh device 1504 each comprise multiple VMM arrays 1601 and activation function blocks 1602. Thus, it can be seen that VMM arrays are particular useful in LSTM cells used in certain neural network systems. The multiplier devices 1506, 1507, and 1508 and the addition device 1509 are implemented in a digital manner or in an analog manner. The activation function blocks 1602 can be implemented in a digital manner or in an analog manner.

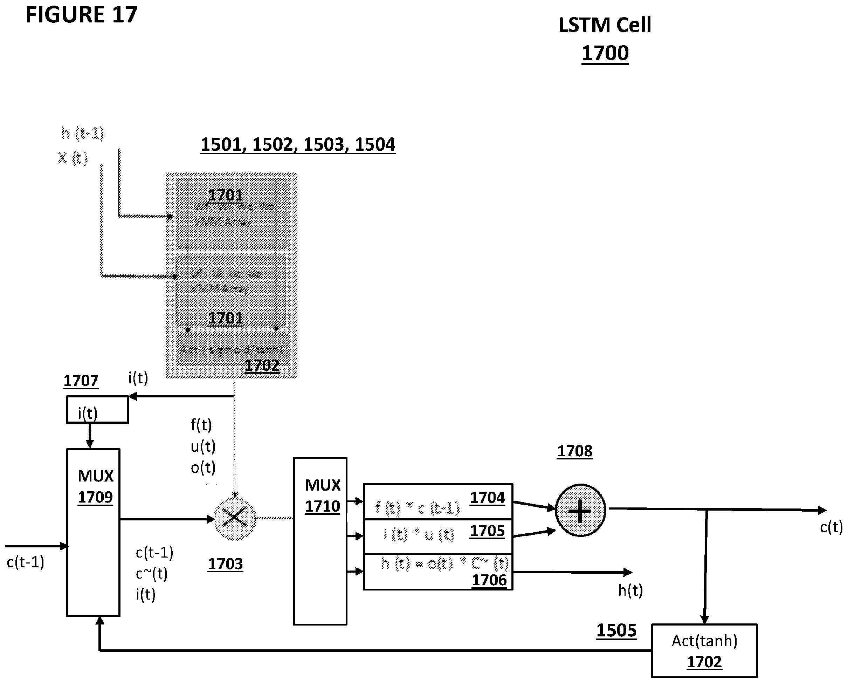

An alternative to LSTM cell 1600 (and another example of an implementation of LSTM cell 1500) is shown in Figure 17. In Figure 17, sigmoid function devices 1501, 1502, and 1503 and tanh device 1504 share the same physical hardware (VMM arrays 1701 and activation function block 1702) in a time-multiplexed fashion. LSTM cell 1700 also comprises multiplier device 1703 to multiply two vectors together, addition device 1708 to add two vectors together, tanh device 1505 (which comprises activation function block 1702), register 1707 to store the value i(t) when i(t) is output from sigmoid function block 1702, register 1704 to store the value f(t) * c(t-1) when that value is output from multiplier device 1703 through multiplexor 1710, register 1705 to store the value i(t) * u(t) when that value is output from multiplier device 1703 through multiplexor 1710, and register 1706 to store the value o(t) * c~(t) when that value is output from multiplier device 1703 through multiplexor 1710, and multiplexor 1709.

Whereas LSTM cell 1600 contains multiple sets of VMM arrays 1601 and respective activation function blocks 1602, LSTM cell 1700 contains only one set of VMM arrays 1701 and activation function block 1702, which are used to represent multiple layers in the example of LSTM cell 1700. LSTM cell 1700 will require less space than LSTM 1600, as LSTM cell 1700 will require 1/4 as much space for VMMs and activation function blocks compared to LSTM cell 1600.

It can be further appreciated that LSTM units will typically comprise multiple VMM arrays, each of which requires functionality provided by certain circuit blocks outside of the VMM arrays, such as a summer and activation function block and high voltage generation blocks. Providing separate circuit blocks for each VMM array would require a significant amount of space within the semiconductor device and would be somewhat inefficient. The examples described below therefore reduce the circuitry required outside of the VMM arrays themselves.

### Gated Recurrent Units

An analog VMM implementation can be utilized for a GRU (gated recurrent unit) system. GRUs are a gating mechanism in recurrent neural networks. GRUs are similar to LSTMs, except that GRU cells generally contain fewer components than an LSTM cell.

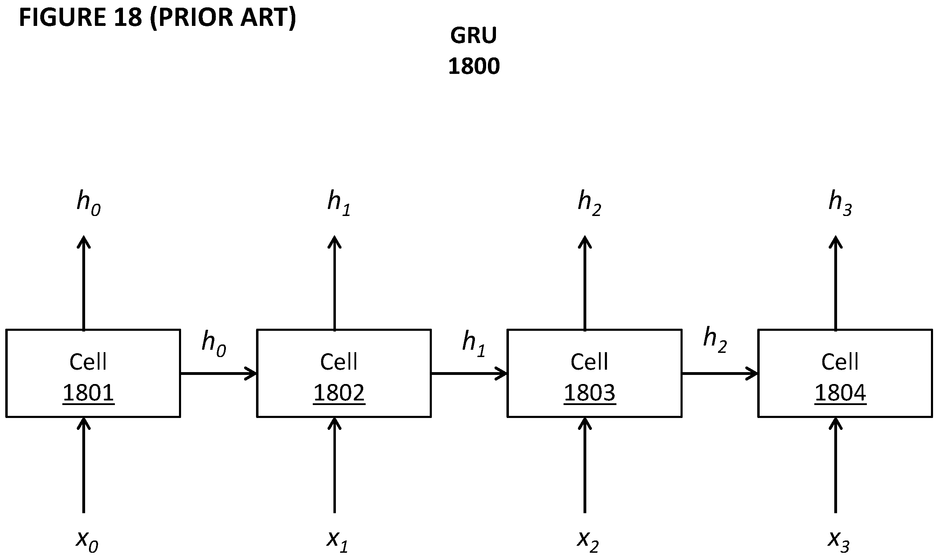

Figure 18 depicts an example GRU 1800. GRU 1800 in this example comprises cells 1801, 1802, 1803, and 1804. Cell 1801 receives input vector x₀ and generates output vector h₀. Cell 1802 receives input vector x₁, the output vector h₀ from cell 1801 and generates output vector h₁. Cell 1803 receives input vector x₂ and the output vector (hidden state) h₁ from cell 1802 and generates output vector h₂. Cell 1804 receives input vector x₃ and the output vector (hidden state) h₂ from cell 1803 and generates output vector h₃. Additional cells can be used, and an GRU with four cells is merely an example.

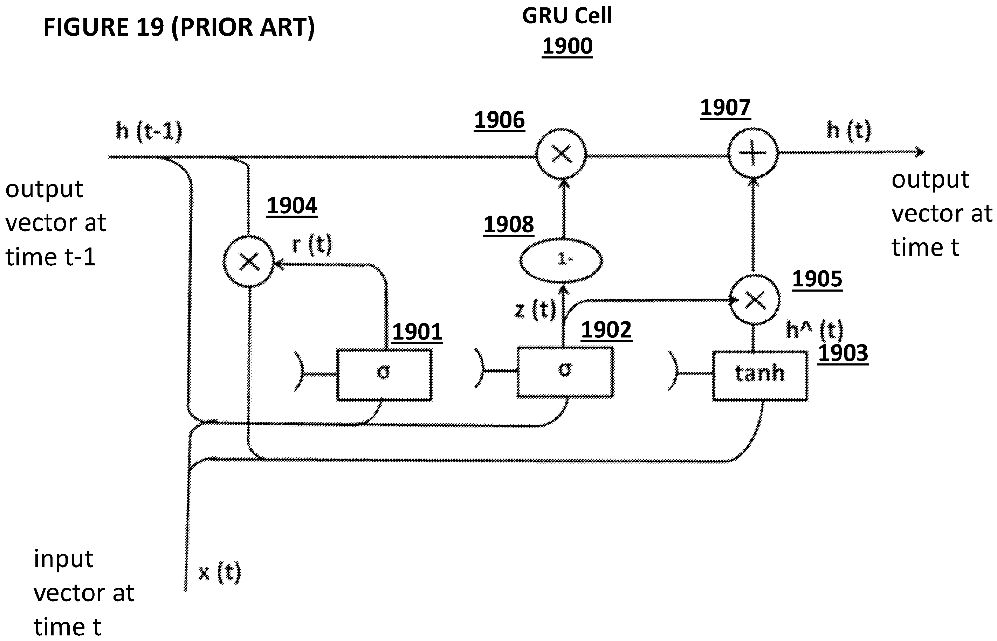

Figure 19 depicts an example implementation of a GRU cell 1900, which can be used for cells 1801, 1802, 1803, and 1804 of Figure 18. GRU cell 1900 receives input vector x(t) and output vector h(t-1) from a preceding GRU cell and generates output vector h(t). GRU cell 1900 comprises sigmoid function devices 1901 and 1902, each of which applies a number between 0 and 1 to components from output vector h(t-1) and input vector x(t). GRU cell 1900 also comprises a tanh device 1903 to apply a hyperbolic tangent function to an input vector, a plurality of multiplier devices 1904, 1905, and 1906 to multiply two vectors together, an addition device 1907 to add two vectors together, and a complementary device 1908 to subtract an input from 1 to generate an output.

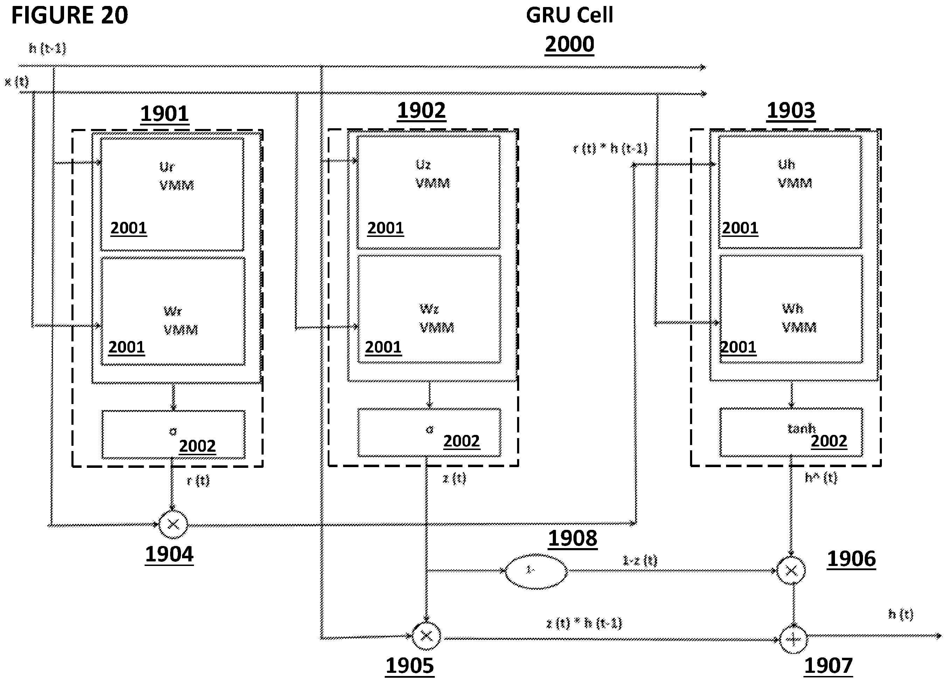

Figure 20 depicts a GRU cell 2000, which is an example of an implementation of GRU cell 1900. For the reader's convenience, the same numbering from GRU cell 1900 is used in GRU cell 2000. As can be seen in Figure 20, sigmoid function devices 1901 and 1902, and tanh device 1903 each comprise multiple VMM arrays 2001 and activation function blocks 2002. Thus, it can be seen that VMM arrays are of particular use in GRU cells used in certain neural network systems. The multiplier devices 1904, 1905, 1906, the addition device 1907, and the complementary device 1908 are implemented in a digital manner or in an analog manner. The activation function blocks 2002 can be implemented in a digital manner or in an analog manner.

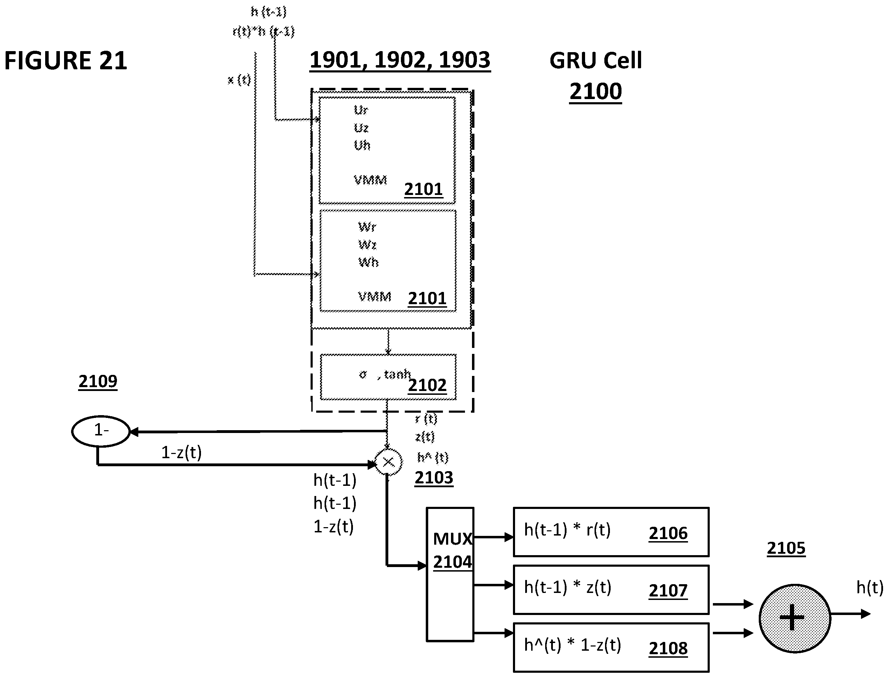

An alternative to GRU cell 2000 (and another example of an implementation of GRU cell 1900) is shown in Figure 21. In Figure 21, GRU cell 2100 utilizes VMM arrays 2101 and activation function block 2102, which when configured as a sigmoid function applies a number between 0 and 1 to control how much of each component in the input vector is allowed through to the output vector. In Figure 21, sigmoid function devices 1901 and 1902 and tanh device 1903 share the same physical hardware (VMM arrays 2101 and activation function block 2102) in a time-multiplexed fashion. GRU cell 2100 also comprises multiplier device 2103 to multiply two vectors together, addition device 2105 to add two vectors together, complementary device 2109 to subtract an input from 1 to generate an output, multiplexor 2104, register 2106 to hold the value h(t-1) * r(t) when that value is output from multiplier device 2103 through multiplexor 2104, register 2107 to hold the value h(t-1) *z(t) when that value is output from multiplier device 2103 through multiplexor 2104, and register 2108 to hold the value h^(t) * (1-z(t)) when that value is output from multiplier device 2103 through multiplexor 2104.

Whereas GRU cell 2000 contains multiple sets of VMM arrays 2001 and activation function blocks 2002, GRU cell 2100 contains only one set of VMM arrays 2101 and activation function block 2102, which are used to represent multiple layers in the example of GRU cell 2100. GRU cell 2100 will require less space than GRU cell 2000, as GRU cell 2100 will require 1/3 as much space for VMMs and activation function blocks compared to GRU cell 2000.

It can be further appreciated that GRU systems will typically comprise multiple VMM arrays, each of which requires functionality provided by certain circuit blocks outside of the VMM arrays, such as a summer and activation function block and high voltage generation blocks. Providing separate circuit blocks for each VMM array would require a significant amount of space within the semiconductor device and would be somewhat inefficient. The examples described below therefore reduce the circuitry required outside of the VMM arrays themselves.

The input to the VMM arrays can be an analog level, a binary level, a pulse, a time modulated pulse, or digital bits (in this case a DAC is needed to convert digital bits to appropriate input analog level) and the output can be an analog level, a binary level, a timing pulse, pulses, or digital bits (in this case an output ADC is needed to convert output analog level into digital bits).

In general, for each memory cell in a VMM array, each weight W can be implemented by a single memory cell or by a differential cell or by two blend memory cells (average of 2 cells). In the differential cell case, two memory cells are needed to implement a weight W as a differential weight (W = W+ - W-). In the two blend memory cells, two memory cells are needed to implement a weight W as an average of two cells.

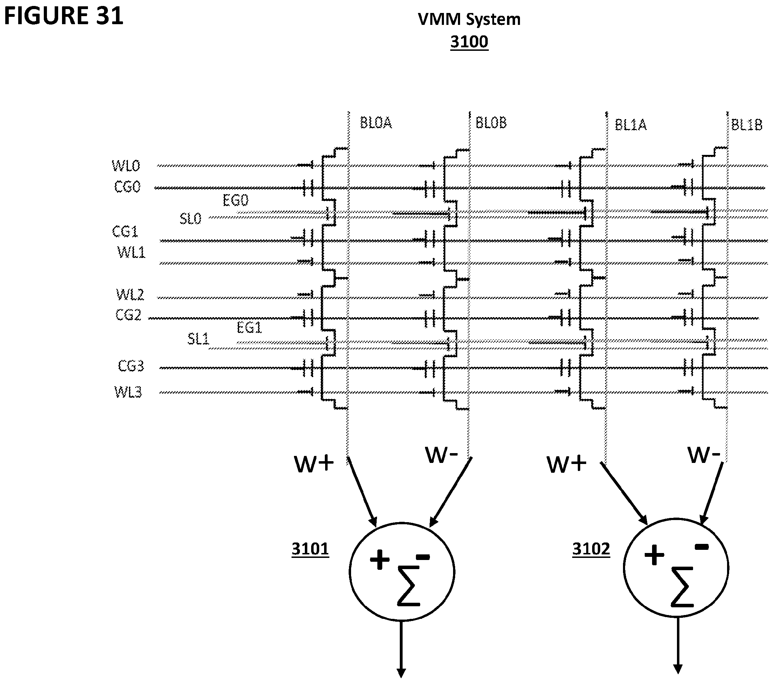

Figure 31 depicts VMM system 3100. In some examples, the weights, W, stored in a VMM array are stored as differential pairs, W+ (positive weight) and W- (negative weight), where W = (W+) - (W-). In VMM system 3100, half of the bit lines are designated as W+ lines, that is, bit lines connecting to memory cells that will store positive weights W+, and the other half of the bit lines are designated as W- lines, that is, bit lines connecting to memory cells implementing negative weights W-. The W- lines are interspersed among the W+ lines in an alternating fashion. The subtraction operation is performed by a summation circuit that receives current from a W+ line and a W- line, such as summation circuits 3101 and 3102. The output of a W+ line and the output of a W- line are combined together to give effectively W = W+ - W- for each pair of (W+, W-) cells for all pairs of (W+, W-) lines. While the above has been described in relation to W- lines interspersed among the W+ lines in an alternating fashion, in other examples W+ lines and W- lines can be arbitrarily located anywhere in the array.

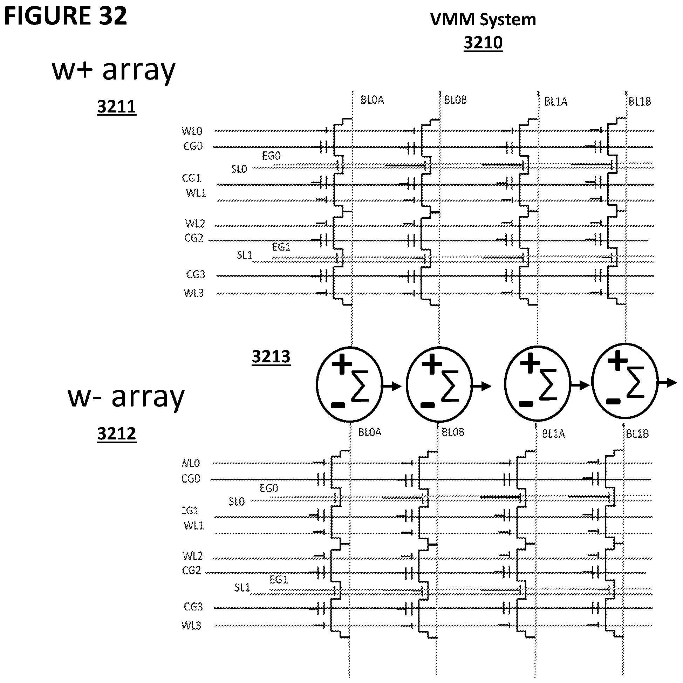

Figure 32 depicts another example. In VMM system 3210, positive weights W+ are implemented in first array 3211 and negative weights W- are implemented in a second array 3212, second array 3212 separate from the first array, and the resulting weights are appropriately combined together by summation circuits 3213.

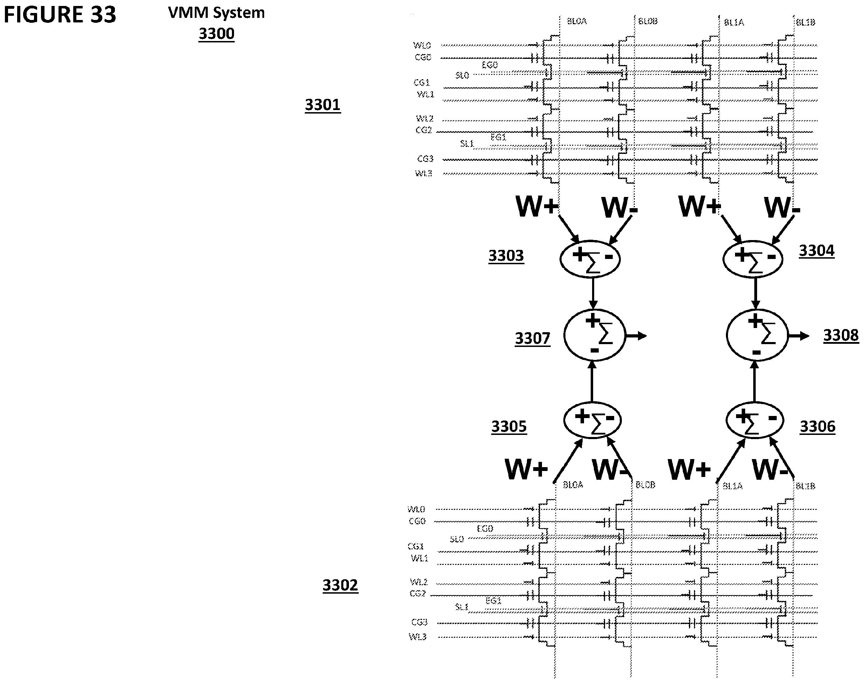

Figure 33 depicts VMM system 3300. the weights, W, stored in a VMM array are stored as differential pairs, W+ (positive weight) and W- (negative weight), where W = (W+) - (W-). VMM system 3300 comprises array 3301 and array 3302. Half of the bit lines in each of array 3301 and 3302 are designated as W+ lines, that is, bit lines connecting to memory cells that will store positive weights W+, and the other half of the bit lines in each of array 3301 and 3302 are designated as W- lines, that is, bit lines connecting to memory cells implementing negative weights W-. The W- lines are interspersed among the W+ lines in an alternating fashion. The subtraction operation is performed by a summation circuit that receives current from a W+ line and a W- line, such as summation circuits 3303, 3304, 3305, and 3306. The output of a W+ line and the output of a W- line from each array 3301, 3302 are respectively combined together to give effectively W = W+ - W- for each pair of (W+, W-) cells for all pairs of (W+, W-) lines. In addition, the W values from each array 3301 and 3302 can be further combined through summation circuits 3307 and 3308, such that each W value is the result of a W value from array 3301 minus a W value from array 3302, meaning that the end result from summation circuits 3307 and 3308 is a differential value of two differential values.

Each non-volatile memory cells used in the analog neural memory system is to be erased and programmed to hold a very specific and precise amount of charge, i.e., the number of electrons, in the floating gate. For example, each floating gate should hold one of N different values, where N is the number of different weights that can be indicated by each cell. Examples of N include 16, 32, 64, 128, and 256.

To ensure accuracy of a VMM system, it is important to compensate for natural variations that occur. For example, the I-V slope can vary within the same memory array due to natural process variations, and it can vary as operating temperature changes. The I-V slope refers to the relationship between the current drawn by a memory cell when a voltage is applied to a terminal of the memory cell, such as the control gate terminal. It would be desirable to be able to compensate for such changes to the I-V slope of part of, or all of the, memory array.

### SUMMARY OF THE INVENTION

The present invention is defined in independent device claim 1 and independent method claim 10. Preferred embodiments are defined in the dependent claims 2-9 and 11-14. Only embodiments comprising all the features of independent device claim 1 or of independent method claim 10 fall under the scope of protection of the present invention.

Numerous examples are described for providing a neural network system comprising a plurality of reference arrays that contain a range of intentional variations so that an appropriate portion of the reference array that closely approximates the operating array can be selected for operations.

### BRIEF DESCRIPTION OF THE DRAWINGS

Figure 1 is a diagram that illustrates an artificial neural network.
Figure 2 depicts a prior art split gate flash memory cell.
Figure 3 depicts another prior art split gate flash memory cell.
Figure 4 depicts another prior art split gate flash memory cell.
Figure 5 depicts another prior art split gate flash memory cell.
Figure 6 is a diagram illustrating the different levels of an exemplary artificial neural network utilizing one or more non-volatile memory arrays.
Figure 7 is a block diagram illustrating a VMM system.
Figure 8 is a block diagram illustrates an example artificial neural network utilizing one or more VMM systems.
Figure 9 depicts another example of a VMM system.
Figure 10 depicts another example of a VMM system.
Figure 11 depicts another example of a VMM system.
Figure 12 depicts another example of a VMM system.
Figure 13 depicts another example t of a VMM system.
Figure 14 depicts a prior art long short-term memory system.
Figure 15 depicts an example cell for use in a long short-term memory system.
Figure 16 depicts an example implementation of the cell of Figure 15.
Figure 17 depicts another example implementation of the cell of Figure 15.
Figure 18 depicts a prior art gated recurrent unit system.
Figure 19 depicts an example cell for use in a gated recurrent unit system.
Figure 20 depicts an example implementation t of the cell of Figure 19.
Figure 21 depicts another example implementation of the cell of Figure 19.
Figure 22 depicts another example of a VMM system.
Figure 23 depicts another example of a VMM system.
Figure 24 depicts another example of a VMM system.
Figure 25 depicts another example of a VMM system.
Figure 26 depicts another example of a VMM system.
Figure 27 depicts another example of a VMM system.
Figure 28 depicts another example of a VMM system.
Figure 29 depicts another example of a VMM system.
Figure 30 depicts another example of a VMM system.
Figure 31 depicts another example of a VMM system.
Figure 32 depicts another example of a VMM system.
Figure 33 depicts another example of a VMM system.
Figure 34 depicts an example of a VMM system.
Figure 35 depicts an example of a VMM array and a reference array.
Figure 36 depicts an example of a VMM array and a reference array.
Figure 37 depicts an example of a VMM array and a reference array.
Figure 38 depicts an example of a reference array.
Figure 39 depicts an example of a reference array.
Figure 40A and 40B depicts physical layouts of an analog array and an embedded reference array.
Figure 41 depicts a reference array selection method.
Figures 42A and 42B depict examples of data of cells with different I-V slopes.
Figure 43 depicts an example of a physical layout of a memory cell.
Figure 44 depicts an example of a calibration circuit.
Figure 45 depicts a row DAC bias generator.
Figure 46 depicts a row DAC bias generator.
Figure 47 depicts a global row DAC decoder.
Figure 48 depicts a global row DAC decoder.
Figure 49 depicts an example layout of reference arrays.
Figure 50 depicts an example layout of reference arrays.
Figure 51 depicts an example layout of reference arrays.

### DETAILED DESCRIPTION OF THE INVENTION

### VMM System Architecture

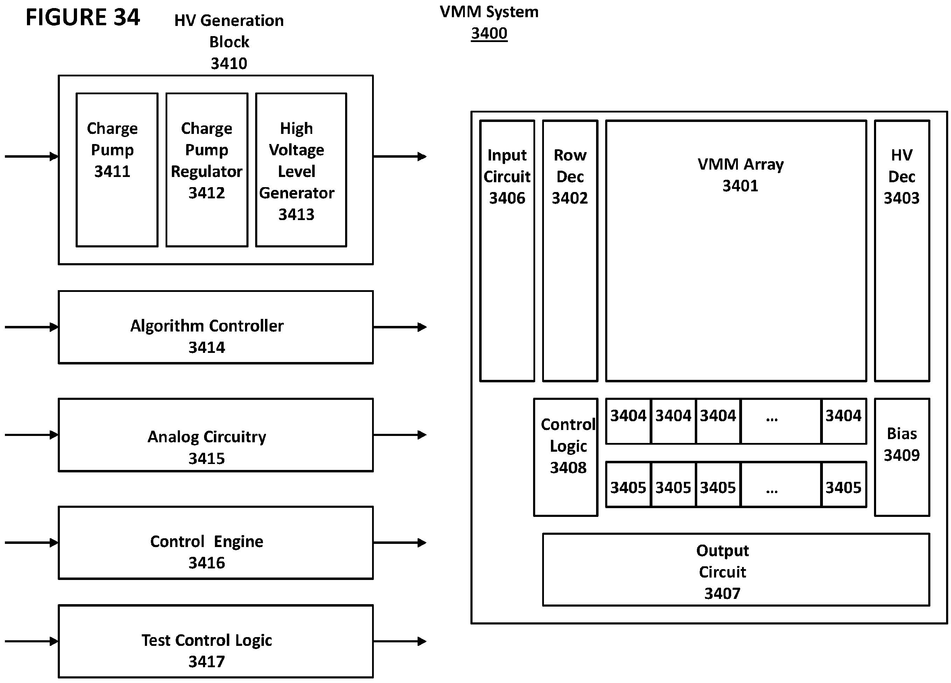

Figure 34 depicts a block diagram of VMM system 3400. VMM system 3400 comprises VMM array 3401, row decoder 3402, high voltage decoder 3403, column decoders 3404, bit line drivers 3405, input circuit 3406, output circuit 3407, control logic 3408, and bias generator 3409. VMM system 3400 further comprises high voltage generation block 3410, which comprises charge pump 3411, charge pump regulator 3412, and high voltage level generator 3413. VMM system 3400 further comprises (program/erase, or weight tuning) algorithm controller 3414, analog circuitry 3415, control engine 3416 (that may include special functions such as arithmetic functions, activation functions, embedded microcontroller logic, without limitation), and test control logic 3417.

The input circuit 3406 may include circuits such as a DAC (digital to analog converter), DPC (digital to pulses converter, digital to time modulated pulse converter), AAC (analog to analog converter, such as a current to voltage converter, logarithmic converter), PAC (pulse to analog level converter), or any other type of converters. The input circuit 3406 may implement one or more of normalization, linear or non-linear up/down scaling functions, or arithmetic functions. The input circuit 3406 may implement a temperature compensation function for input levels. The input circuit 3406 may implement an activation function such as ReLU or sigmoid.

The output circuit 3407 may include circuits such as an ADC (analog to digital converter, to convert neuron analog output to digital bits), AAC (analog to analog converter, such as a current to voltage converter, logarithmic converter), APC (analog to pulse(s) converter, analog to time modulated pulse converter), or any other type of converters. The output circuit 3407 may implement an activation function such as rectified linear activation function (ReLU) or sigmoid. The output circuit 3407 may implement one or more of statistic normalization, regularization, up/down scaling/gain functions, statistical rounding, or arithmetic functions (e.g., add, subtract, divide, multiply, shift, log) for neuron outputs. The output circuit 3407 may implement a temperature compensation function for neuron outputs or array outputs (such as bitline output) so as to keep power consumption of the array approximately constant or to improve precision of the array (neuron) outputs such as by keeping the IV slope approximately the same.

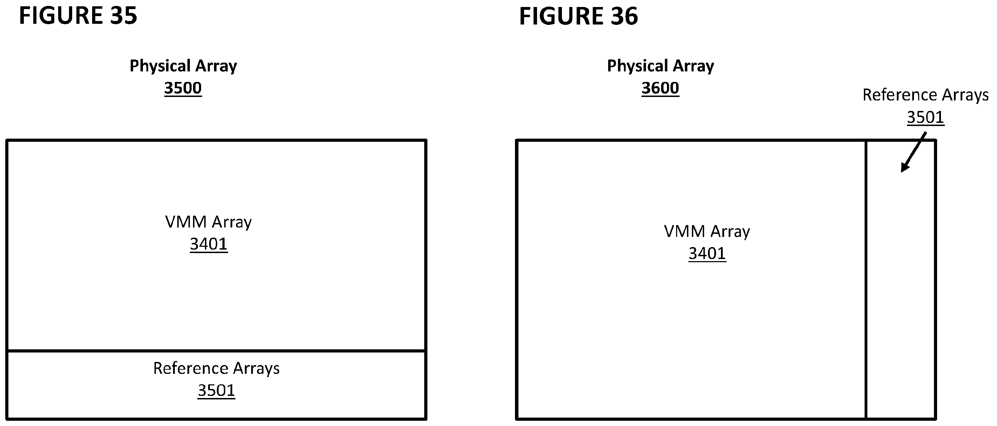

Figures 35 and 36 depict examples of reference arrays embedded into the same physical arrays as the VMM arrays.

Figure 35 depicts physical array 3500. Physical array 3500 optionally comprises an array of non-volatile memory cells. The non-volatile memory cells optionally can comprise stacked-gate flash memory cells or split-gate flash memory cells.

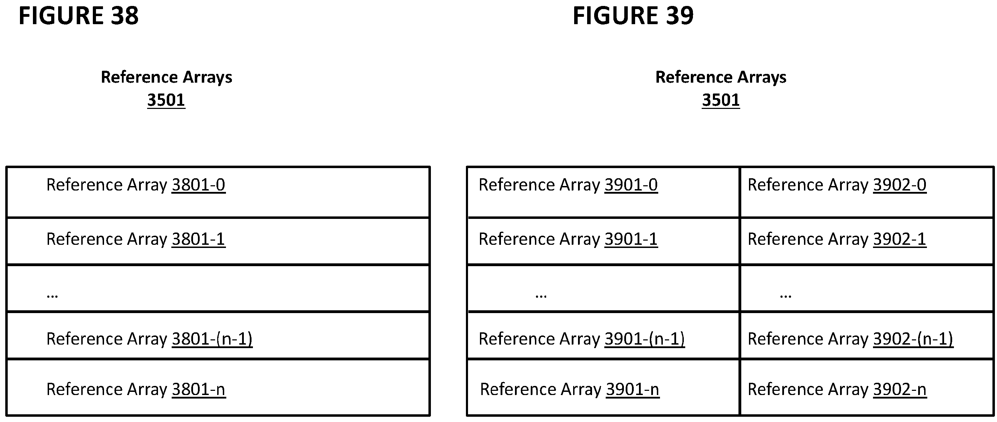

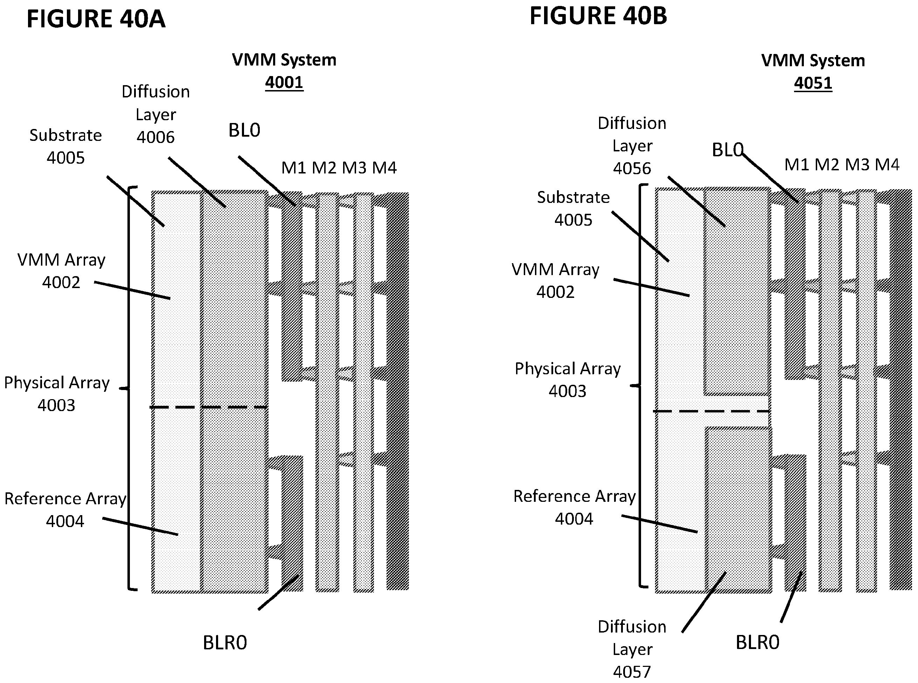

Physical array 3500 is divided into two types of arrays, VMM array 3401 (as in Figure 34) and reference arrays 3501. Reference arrays 3501 comprise a plurality of reference arrays, as shown in Figures 38 and 39. In one example, VMM array 3401 and reference arrays 3501 share the same bit lines. In another example, VMM array 3401 and reference arrays 3501 use separate sets of bit lines, where the two sets of bit lines are disconnected. Example physical layouts are shown in Figures 40A and 40B.

Figure 36 depicts physical array 3600, which is divided into two arrays, VMM array 3401 and reference arrays 3501. In one example, VMM array 3401 and reference arrays 3501 share one or more sets of horizontal lines, such as word lines, control gate lines, and erase lines. In another example, VMM array 3401 and reference arrays 3501 do not share any sets of horizontal lines.

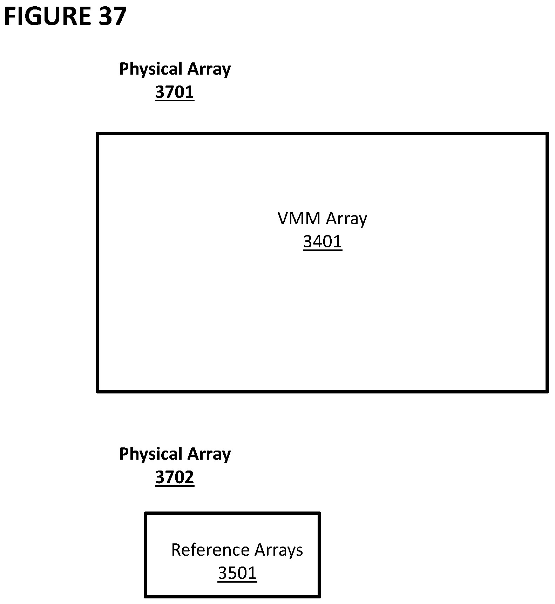

Figure 37 depicts an example where reference arrays 3501 and VMM array 3401 are located in separate physical arrays. For example, there can be a substrate separation or active diffusion separation between the two arrays. Physical array 3701 contains VMM array 3401, and physical array 3702 contains reference arrays 3501. VMM array 3401 and reference arrays 3501 do not share any bit lines, word lines, control gate lines, or erase lines.

Figure 38 depicts an example of reference arrays 3501. Here, reference arrays 3501 comprise a plurality of reference arrays, such as reference arrays 3801-0, 3801-1,..., 3801-(n-1), and 3801-n. Thus, reference arrays 3501 comprise n+1 different reference arrays. The different reference arrays can have different characteristics that cause respective reference arrays to be characterized by a different I-V curve than the other reference arrays. For example, respective reference arrays can vary in its dimensions of one of more of the following: (1) width of a control gate line of transistors of the respective reference array; (2) width of a word line of transistors of the respective reference array; (3) width of a floating gate of transistors of the respective reference array; (4) overall width of a non-volatile memory cell in the respective reference array; (5) shallow trench isolation (STI) spacing within the respective reference array; or (6) other characteristics. Furthermore, reference arrays can respectively vary in one or more device implant conditions or doping characteristics (such as well implant conditions, source implant conditions, drain implant conditions, without limitation).

Figure 39 depicts another example of reference arrays 3501. Here, reference arrays 3501 comprises a plurality of reference arrays, such as reference arrays 3901-0, 3901-1,..., 3901-(n-1), and 3901-n and 3901-0, 3902-1,..., 3902-(n-1), and 3902-n. Thus, reference array 3501 comprises 2*(n+1) different reference arrays. As in Figure 38, the different reference arrays can have different characteristics that cause the respective reference array to be characterized by a different I-V curve than the other reference arrays. For example, respective reference arrays can vary in its dimensions of one of more of the following: control gate width, word line width, floating gate width, overall width of a non-volatile memory cell in the array, STI spacing, and device implant condition, without limitation.

Figure 40A depicts physical layout of a VMM array and a reference array. VMM system 4001 comprises VMM array 4002 and reference array 4004. Example bit line BL0 is coupled to VMM array 4002 and example bit line BLR0 is coupled to reference array 4004. The bit line BL0, coupled to VMM array 4002, may be termed VMM array bit line BL0, as examples use metal layers M1 to M4 in VMM array 4002, and metal layers M2 to M4 also connect to peripheral circuitry (such as a column decoder), whereas bit line BLR0, coupled to reference array 4004, may be termed reference array bit line BLR0, as examples use metal layer M1 only as example. VMM array 4002 and reference array 4004 are part of the same physical array 4003. Physical array 4003 comprises substrate 4005 and diffusion layer 4006, which are both shared by VMM array 4002 and reference array 4004. Physical array 4003 is partitioned electrically by using disconnected metal interconnects for VMM array 4002 and reference array 4004. For example, as can be seen, VMM array metal bit line BL0 and reference array metal bit line BLR0 both use metal layer M1 but are disconnected from one another. Using the same physical array 4003 for both VMM array 4002 and reference array 4004 reduces any physical effect from process uniformity and area overhead which would occur in the use of separate physical arrays.

Figure 40B depicts another embodiment of the physical layout for the VMM array and reference array which is similar to that in Figure 40A except in this VMM system 4051, the diffusion layer 4056 for the VMM array 4052 and the diffusion layer 4057 for the reference array 4004 are separated.

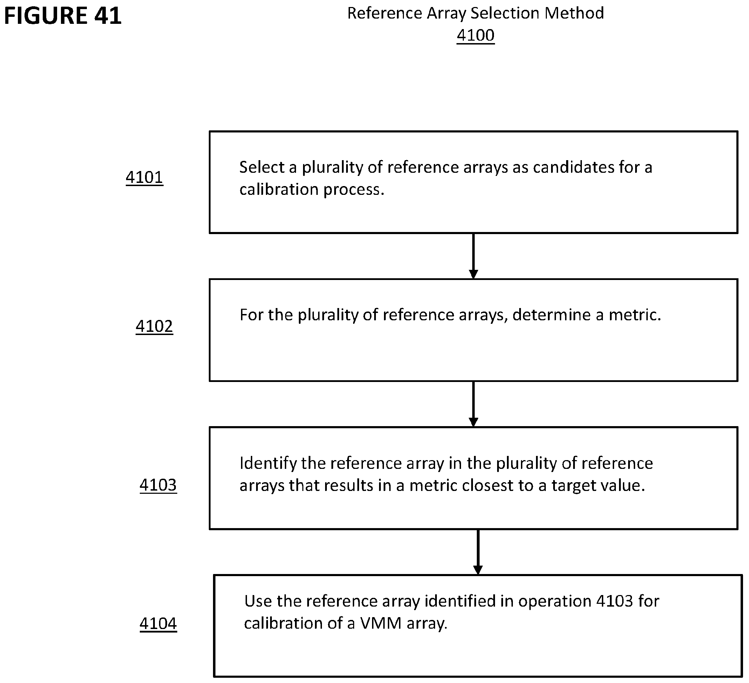

Figure 41 depicts reference array selection method 4100 which is performed to calibrate a VMM system. Method 4100 can be performed during a manufacturing or testing process, or it can be performed during real-time operation of the VMM system. In operation 4101, a plurality of reference arrays are selected as candidates for a calibration process. For example, a plurality of reference arrays are selected as candidates to adjust an I-V (current-voltage) slope of a VMM array. In operation 4102, for the plurality of reference arrays, a respective metric is determined. The metric can be, for example, a target circuit performance metric or a target neural network performance metric. In operation 4103, the reference array in the plurality of reference arrays that results in a metric closest to a target value is identified. In operation 4104, the reference array identified in operation 4103 is used for calibration of a VMM array.

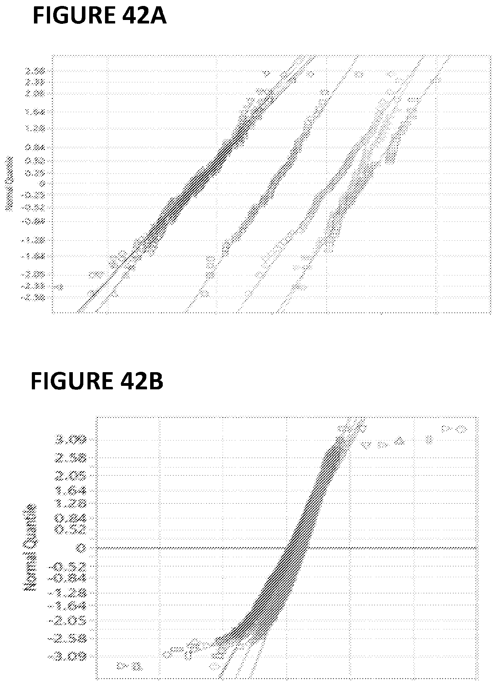

Figure 42A depicts data captured from memory arrays with different physical characteristics. Figure 42B depicts data captured from memory arrays with different electrical characteristics (such as by well implant). As can be seen, the I-V slope for memory cells can vary based on physical or electrical variations among memory cells.

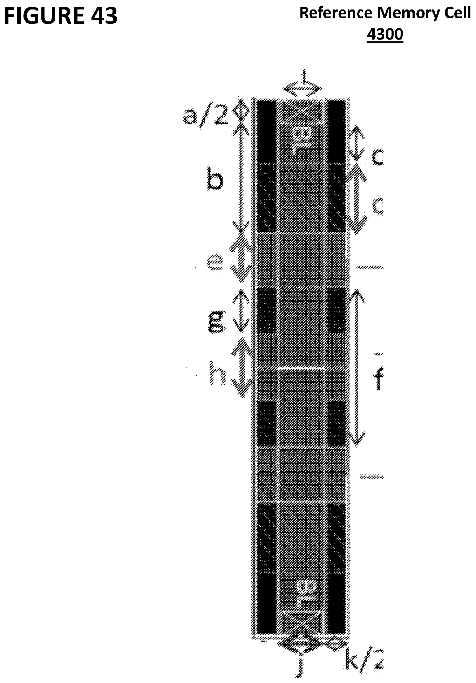

Figure 43 depicts an example of a physical layout of reference memory cell 4300 in reference arrays 3501, where one can appreciate that the dimensions of control gate width, word line width, floating gate width, overall width, and STI spacing can vary based on the manufacturing process and layout that are used. These are examples of the characteristics referred to above with reference to Figures 38 and 39 that can be varied from reference array to reference array.

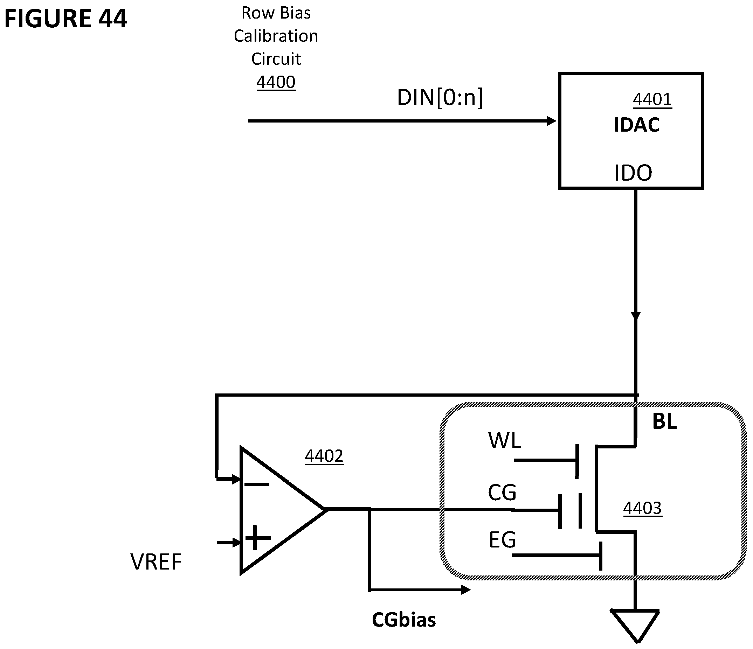

Figures 44 to 48 provide examples of how reference arrays 3501 can be used to calibrate VMM array 3401.

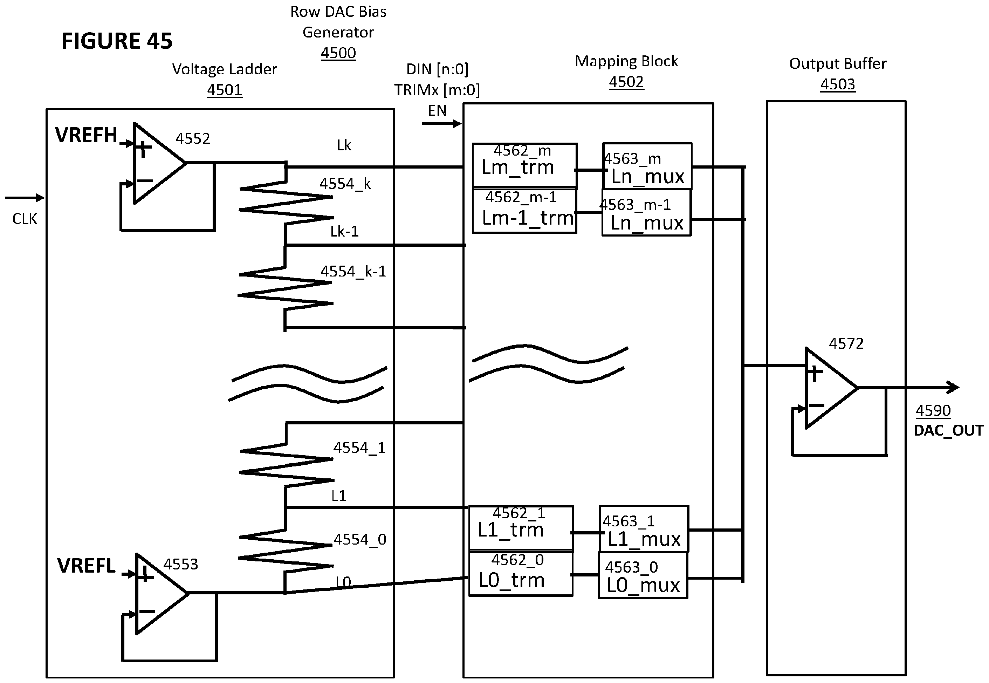

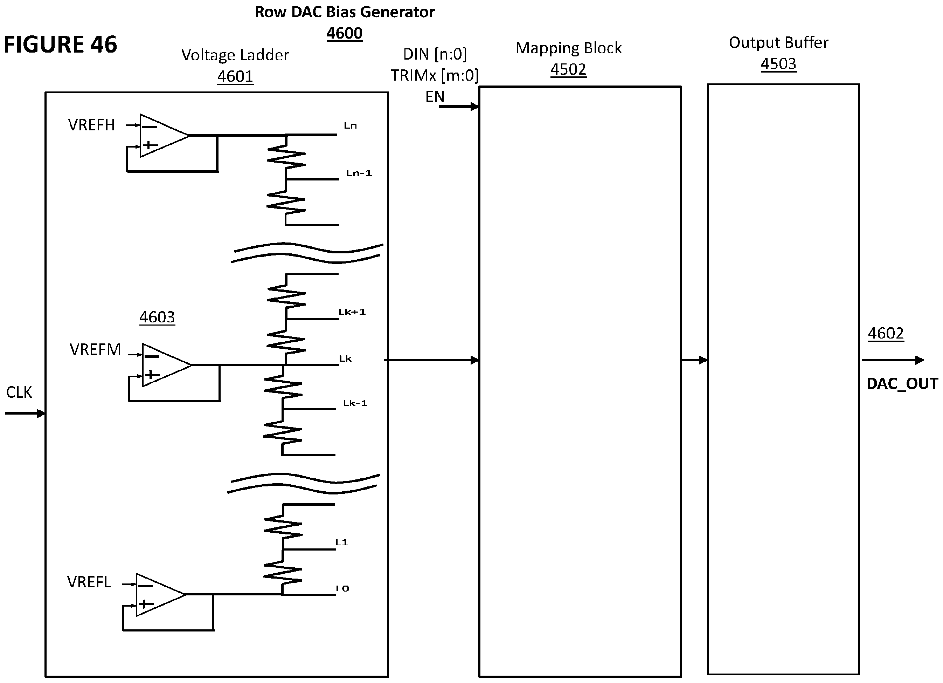

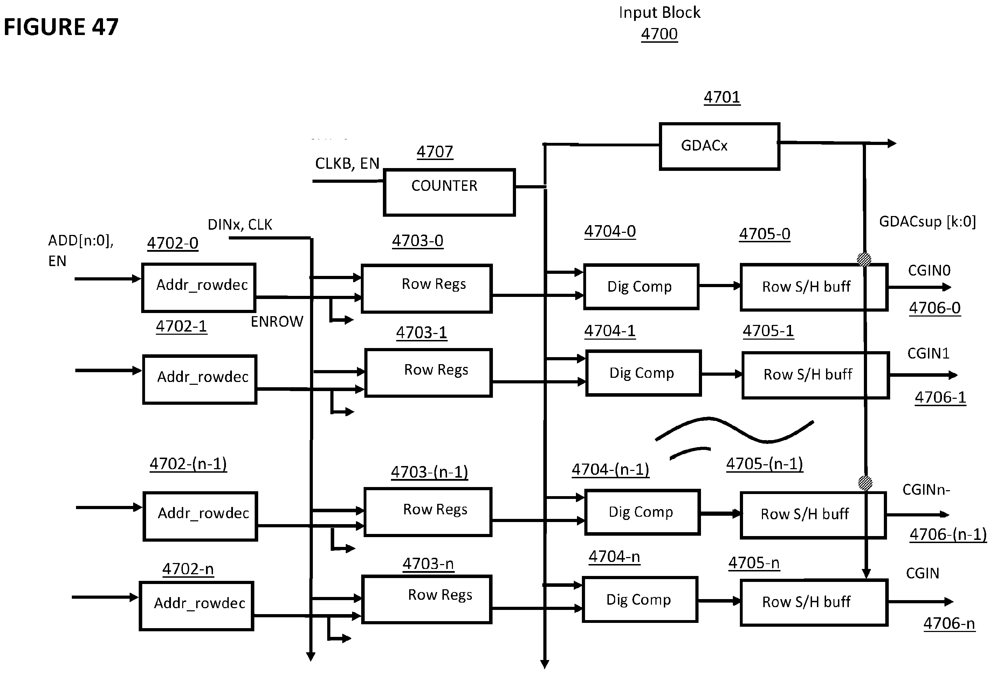

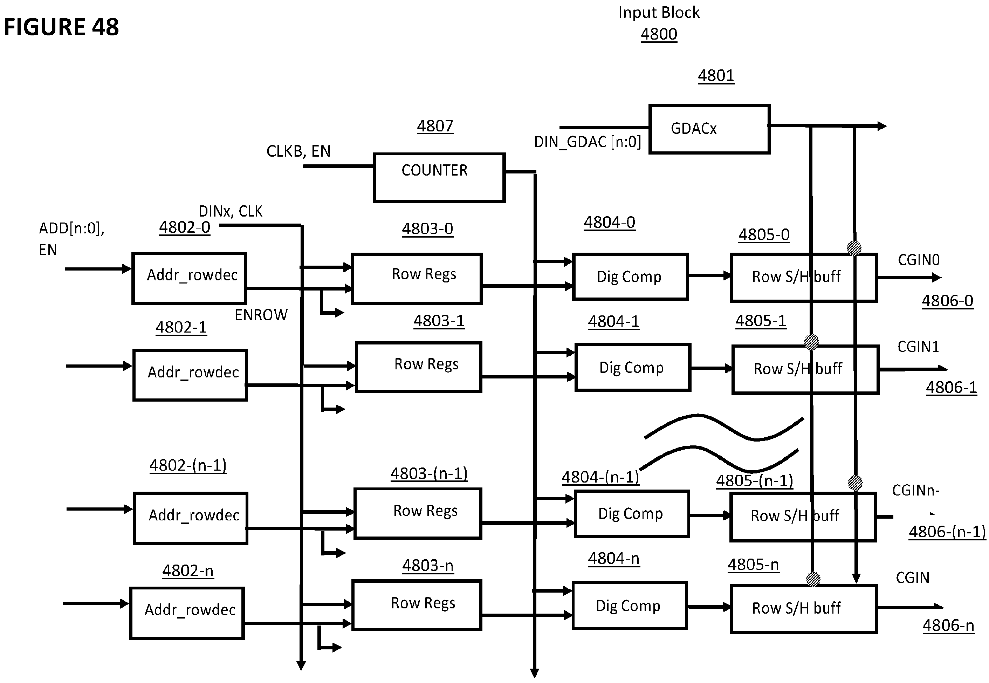

Figure 44 depicts an example row bias calibration circuit 4400, which comprises current digital-to-analog converter (DAC) 4401, op-amp 4402, and reference memory cell 4403. Reference memory cell 4403 can be a reference cell in reference arrays of Figures 35-39. Row bias calibration circuit 4400 provides reference CG bias. CG bias can then be applied directly to CG terminals in a VMM array to provide a bias voltage on those cells, or CG bias can be used in larger systems such as row DAC bias generator 4500 in Figure 45, row DAC bias generator 4600 in Figure 46, input block 4700 in Figure 47, or input block 4800 in Figure 48 that in turn generate bias voltages that can be applied to CG terminals or other terminals in a VMM array to provide a bias voltage on those cells.

Reference memory cell 4403 can specifically be from the reference array selected in operation 4103 of method 4100 in Figure 41. The input, DIN[0:n], selects a current generated by current DAC 4401. The current that is generated is a target current that a memory cell in VMM array 3401 ideally will generate for a stored weight corresponding to the value of DIN[0:n]. For example, if DIN is an 8-bit value, there will be 256 possible values for DIN and 256 respective current levels that ideally will be generated during a read operation on a memory cell in VMM array 3401 that is storing a weight corresponding to that value.

Op-amp 4402 outputs a voltage on terminal CG, CGbias, of reference memory cell 4403. Based on the inherent nature of operational amplifiers, op-amp 4402 adjusts this output voltage until the voltage on its inverting input terminal is equal to the voltage, VREF (which can be an arbitrary reference value, such as 0.5V), on its non-inverting input terminal. The output voltage of op-amp 4402 is sampled and can be applied to control gate terminals of memory cells in VMM array 3401 as a bias voltage, or alternatively as an analog input to the array. Alternatively, CGbias can be used in systems such as row DAC bias generator 4500 in Figure 45, row DAC bias generator 4600 in Figure 46, input block 4700 in Figure 47, or input block 4800 in Figure 48.

Reference cell 4403 can be a single cell or can comprise multiple cells. For example, multiple reference cells can be used to obtain an averaging effect or to reflect the weight distribution of a layer of a neural network. For example, multiple reference cells can be selected such that 50% of the reference cells reflect low weight values, 20% of the reference cells reflect medium weight values, and 30% of the reference cells reflect high weight values, in an attempt to approximate the typical weight distribution in a VMM array in an artificial neural network.

Or, for example, different instantiations of row bias calibration circuit 4400 can be used to generate different CGbias levels, such as high, medium, and low CGbias levels. For example, a low CGbias level (VREFL) can be generated using a number of reference cells (e.g., 1 cell, 2 cells, ... 32 cells) where each cell has a target current of 3 nA (generated by current digital-to-analog converter 4401) representing the 1stlevel of 32 levels of the memory cells for a 5-bit cell; a high CGbias level (VREFH) can be generated using a number of reference cells (e.g., 1 cells, 2 cells,...32 cells), where each cell has a target current of 96 nA representing the 32nd level of 32 levels of the memory cells for a 5-bit cell; and a medium CGbias level (VREFM) can be generated using a number of reference cells (e.g., 1 cells, 2 cells, ..., 32 cells), where each cells has a target current of 48 nA representing the 16th level of 32 levels of the memory cells for 5-bit cell. In this manner, three instances of row bias calibration circuit 4400 can be used to generate a high voltage VREFH, a medium voltage VREFM, and a low voltage VREFL.

For the case of a serial DAC input (such as an input comprising a sequence of one digital input bit applied at a time, where the corresponding digital outputs are shifted and added for each binary input bit position) or a timed input (pulse-width modulation input or pulse count input), a CG bias voltage that is applied to the VMM array can be provided by row bias calibration circuit 4400 of Figure 44.

Figure 45 depicts row DAC bias generator 4500, which comprises voltage ladder 4501, mapping block 4502, and output buffer 4503. Voltage ladder 4501 generates a plurality of voltage levels (L0, ..., Lk), which respectively provide a voltage to a VMM array to cause the VMM array to operate in either the linear mode or the sub-threshold mode, depending on the voltage mode (linear or sub threshold) selected. For sub-threshold operation, for example, voltage ladder 4501 might have 8-14 bits of resolution. Control logic (not shown) controls the operation of row DAC bias generator 4500 (by performing functions such as enabling various blocks using enable signals, such as EN, providing control signals to multiplexors, and other control functions).

The mapping block 4502 translates the levels from voltage ladder 4501 into a respective analog output, such as a voltage representing an 8-bit output, and the output of mapping block 4502 is fed to output buffer 4503.

The output of output buffer 4503 is depicted as DAC_OUT 4590, which is then applied to a row of memory cells in a VMM array as a bias voltage (such as on a CG terminal) to alter the I-V slope of those cells. Local trimming for each level (represented by trim blocks L0_trm,...Ln_trm) is provided within mapping block 4502, at least when the array is operating in the sub-threshold region. Applying this bias voltage to, for example, the control gate line of the row of memory cells will achieve a non-linear I-V slope for the memory cells in the VMM array over a temperature range in the sub-threshold region. It can be appreciated that DAC_Out 4590 is generated using multiple reference arrays (for example, one reference array to generate VREFH and another reference array to generate VREFL).

Voltage ladder 4501 receives a high reference voltage, VREFH (such as VREFH generated by an instantiation of row bias calibration circuit 4400 in Figure 44, described above), and a low reference voltage, VREFL (such as VREFL generated by an instantiation of row bias calibration circuit 4400 in Figure 44, described above). VREFH corresponds to the highest possible value that can be stored in a cell in a VMM array, and VREFL corresponds to the lowest possible value that can be stored in a cell in a VMM array. Voltage ladder 4501 comprises a plurality of resistors that are used to generate a range of voltages between VREFL and VREFH, optionally according to a linear function or a logarithmic function. For example, the top node of the top resistor in the voltage ladder will have a voltage VREFH, and the bottom of the resistor will have a lower voltage due to a voltage drop across the top resistor. The bottom node of the bottom resistor will have a voltage VREFL. The voltage ladder thereby generates a plurality of voltage levels (L0, ..., Lk) (for example, k might be 4095), which are needed when it is desired to provide a voltage to a VMM array to cause the non-volatile memory cells of the VMM array to operate in linear mode or sub-threshold mode.

Mapping block 4502 receives digital input DIN [n:0], which is used to select one of the m+1 analog voltages using sub blocks 4563 inside mapping block 4502, where (m+1) = 2^(n+1). For example, if (n+1)=8, then (m+1)=256. Mapping block 4502 comprises (m+1) trim blocks 4562 and (m+1) multiplexors 4563. Mapping block 4502 translates the k+1 voltage levels from the DAC 4501 into a respective analog output corresponding to DIN[n:0]. This is achieved with local trimming for each level (represented by trim blocks L0_trm,...Lm_trm), which may be useful, for example, when the non-volatile memory cells in the array are operating in the sub-threshold region. This is desirable to achieve a best matching I-V slope for the non-volatile memory cells in the VMM array over temperature in sub threshold region or linear region.

By adjusting reference voltages VREFL and VREFH, the range of the k+1 levels are adjusted as well. This is, for example, to match the output range of this input block with an input range of the memory cells. This also can be performed for temperature compensation by adjusting (such as shifting lower at high temperature and higher at lower temperature) the reference levels VREFL and VREFH to achieve the desired range of gate bias of the memory cells that may be required due to temperature variations. Further individual level adjustment and temperature compensation is done by level trimming circuits of mapping block 4502 for example for best neural network accuracy.

Figure 46 depicts row DAC bias generator 4600. Row DAC bias generator 4600 is similar to row DAC bias generator 4500 except for the use of voltage ladder 4601 instead of voltage ladder 4501. Voltage ladder 4601 is similar to voltage ladder 4501 with the addition of intermediate middle reference level VREFM (such as VREFM generated by an instantiation of row bias calibration circuit 4400 in Figure 44, described above). The adjustment and temperature behavior of VREFM reference levels are controlled similarly to that of the VREFH and VREFL reference levels. It includes additional buffer 4603 to impose middle reference levels into the ladder to further adjust the I-V slope matching of the GDAC 5480 and the input of the memory array. Although voltage ladder 4601 uses three voltage reference levels (VREFH, VREFM, and VREFL), it can be understood that other numbers of voltage reference levels can be used instead.

The reference voltages are generated from the CGbias outputs of instantiations of row bias calibration circuits 4400 in Figure 44 using a reference memory cell 4403 from n+1 reference arrays 3801 or 3901. Row DAC bias generator 4600 provides the bias voltage (DAC_OUT 4602) to be applied to the rows of the VMM arrays.

Figure 47 depicts example input block 4700 to be used to provide inputs to a VMM array, such as VMM array 3401 in Figure 34. Input block 4700 comprises global digital-to-analog converter (DAC) 4701; address row decoders 4702-0 to 4702-n, each corresponding to one of the rows numbered 0 through n in the VMM array; row registers 4703-0 through 4703-n, each corresponding to one of the rows numbered 0 through n in the VMM array; digital comparator blocks 4704-0 through 4704-n, each corresponding to one of the rows numbered 0 through n in the VMM array; row sample-and-hold (S/H) buffers 4705-0 through 4705-n, each corresponding to one of the rows numbered 0 through n in the VMM array; output signals 4706-0 through 4706-n, each corresponding to one of the rows numbered 0 through n in the VMM array, and counter 4707.

Global DAC 4701 optionally can comprise row DAC bias generator 4500 in Figure 45 or row DAC bias generator 4600 in Figure 46, with the reference voltage levels VREFH, VREFL, and optionally VREFM provided by instantiations of row bias calibration circuit 4400 in Figure 44.

Each set of a row register 4703, digital comparator 4704, and row sample-and-hold buffer 4705 for a particular row can be considered a local digital-to-analog converter for that particular row, where the voltage supply for that local digital-to-analog converter is provided by global DAC 4701, as explained below.

Address row decoders 4702-0 to 4702-n receive a row address, ADD[n:0], and an enable signal, EN. The output of each address row decoder, denoted ENROW, is high when ADD[n:0] is the address for that particular row and when EN is asserted. Row registers 4703-0 through 4703-n are loaded with respective digital input bits DINx (where x is the number of bits, such as 8 or 16 bits) for that particular row, where the loading operation is triggered by a clock signal, CLK, where DINx is the activation input for that particular row, to perform the vector-by-multiplication matrix operation. When the output of a particular address row decoder 4702 is high, the associated row register 4703 is enabled and outputs its digital bits, DINx. Counter 4707 counts the pulses in another clock signal, CLKB, when enabled by signal EN. The output of counter 4707 is a count value. Digital comparator blocks 4704-0 to 4704-n compare the activation value, DINx, stored in the each of the respective row registers 4703 against the count value. If the count value matches the value stored in a particular row register 4702, then the respective digital comparator block 4704 enables the corresponding row S/H buffer 4705 to sample and hold the analog output value from global DAC 4701. Global DAC 4701 performs digital-to-analog conversion on the count value (which also matches the DINx for the row register 4703 for the row in question). Each row S/H buffer 4705 outputs the held analog value as output signal 4706. If, for example, x=8 and DINx is an 8-bit input (meaning that there are 256 different values for DINx), then counter 4707 will count up to 256 and then reset. In doing so, it will have covered all possible values of DINx, and each row S/H buffer 4705 will have been loaded with its associated value of DINx.

Output signal 4706 can be applied, for example, to a control gate line or a word line during a programming or read operation in that particular row or during a neural read operation where all rows are read. During a neural read, all S/H buffers 4705 are enabled to drive the array input terminals through respective output signals 4706, resulting in bitline currents being output by the VMM array, which are then processed by output circuits, such as ITV (current to voltage converter) circuits and ADC (analog-to-digital converter) circuits.

Each respective output signal 4706 can be applied, for example, to a respective control gate line or a word line during a programming or read operation in that particular row.

In another example, a row sample-and-hold buffer 4704 can be shared by multiple rows in a time-multiplexed fashion.

Figure 48 depicts an example input block 4800 to be used to provide inputs to a VMM array, such as VMM array 3401 in Figure 34. Input block 4800 is similar to input block 4400 in Figure 44 but provides multiple outputs from global digital-to-analog converter for a neural read operation. Input block 4800 comprises global digital-to-analog converter 4801; address row decoders 4802-0 to 4802-n, each corresponding to a respective one of the rows numbered 0 through n; row registers 4803-0 through 4803-n, each corresponding to a respective one of the rows numbered 0 through n; digital comparators 4804 through 4804-n, each corresponding to a respective one of the rows numbered 0 through n; row sample-and-hold buffers 4805-0 through 4805-n, each corresponding to a respective one of the rows numbered 0 through n; and output signals 4806-0 through 4806-n, each corresponding to a respective one of the rows numbered 0 through n.

Global DAC 4801 optionally can comprise row DAC bias generator 4500 in Figure 45 or row DAC bias generator 4600 in Figure 46, with the reference voltage levels VREFH, VREFL, and optionally VREFM provided by instantiations of row bias calibration circuit 4400 in Figure 44.

Address row decoders 4802-0 to 4802-n receive a row address, ADD[n:0], and an enable signal, EN. The output of each address row decoder 4802, denoted ENROW, is high when ADD[n:0] is the address for that particular row and EN is asserted. Row registers 4803-0 through 4803-n are loaded with respective digital input bits DINx (where x is the number of bits, such as 8 or 16 bits), where the loading is triggered by clock signal, CLK, for that particular row, where DINx is the activation input for that particular row. When the output, ENROW, of a particular address row decoder 4802 is high, the associated row register 4803 is enabled and outputs its digital bits, DINx. Counter 4807, when enabled by signal EN, counts the pulses in another clock signal, CLKB. The output of counter 4807 is a count value. Digital comparator blocks 4804-0 to 4804-n compare the activation value, DINx, stored in the each of the respective row registers 4803 against the count value. If the count value matches the value stored in a particular row register 4802, then the corresponding row S/H buffer 4805 is enabled by the respective digital comparator block 4804 to sample and hold the analog output value from GDAC 4801. As shown, there are two vertical analog output lines from GDAC 4801. For example, for an 8-bit GDAC 4801, one line can deliver outputs for 0 to 127 analog levels (corresponding to 00000000 to 01111111) and the other line can deliver outputs for 128 to 255 analog levels (corresponding to 10000000 to 11111111). Both lines can operate at the same times to cut the row DAC sampling times from 256 (DAC) clocks to 128 (DAC) clocks. Each row S/H buffer 4805 receives only one of the outputs from GDAC 4801. Output signal 4806 can be applied, for example, to a control gate line or a word line during a programming operation in that particular row.

Optionally, global digital-to-analog converter 4801 can comprise a first global DAC for odd rows and a second global DAC for even rows.

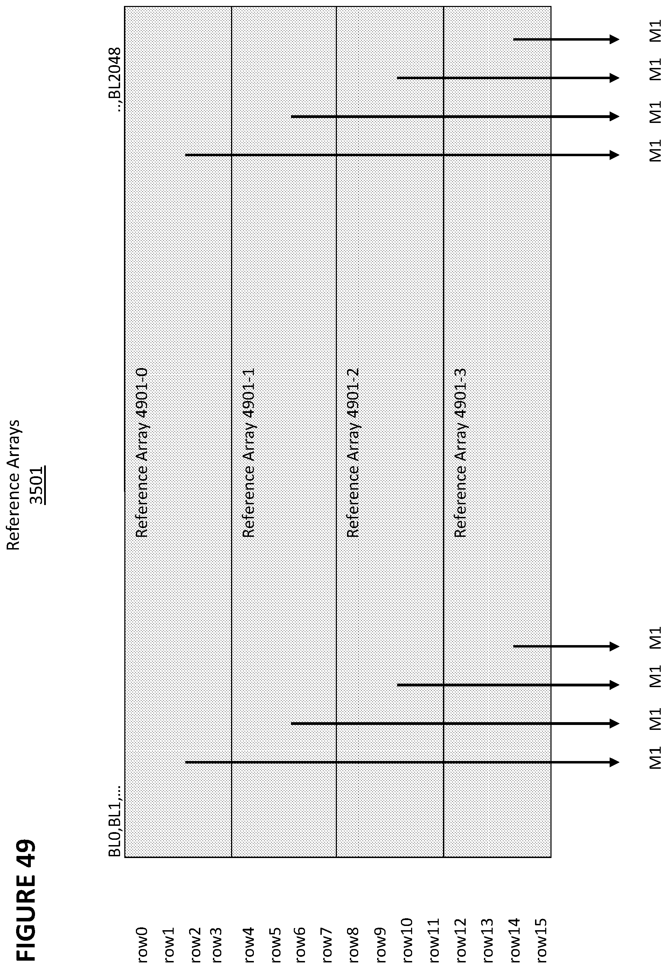

Figure 49 depicts an example layout of reference arrays 3501. Reference arrays 3501 comprise reference arrays 4901-0, 4901-1, 4901-2, and 4901-3, which are coupled to respective shared bitlines in the same metal layer, such as metal layer M1. Respective reference arrays 4901, for example, can implement low level (VREFL), middle level (VREFM), or high level (VREFH) CG reference biases described above in relation to Figures 44-46, without limitation. When a particular bitline is used for one reference array, the cells in the other reference arrays that are connected to that bitline are deeply programmed so that they do not conduct any current and are essentially disabled. In this manner, each bitline can effectively be dedicated to use by only one of the reference arrays.

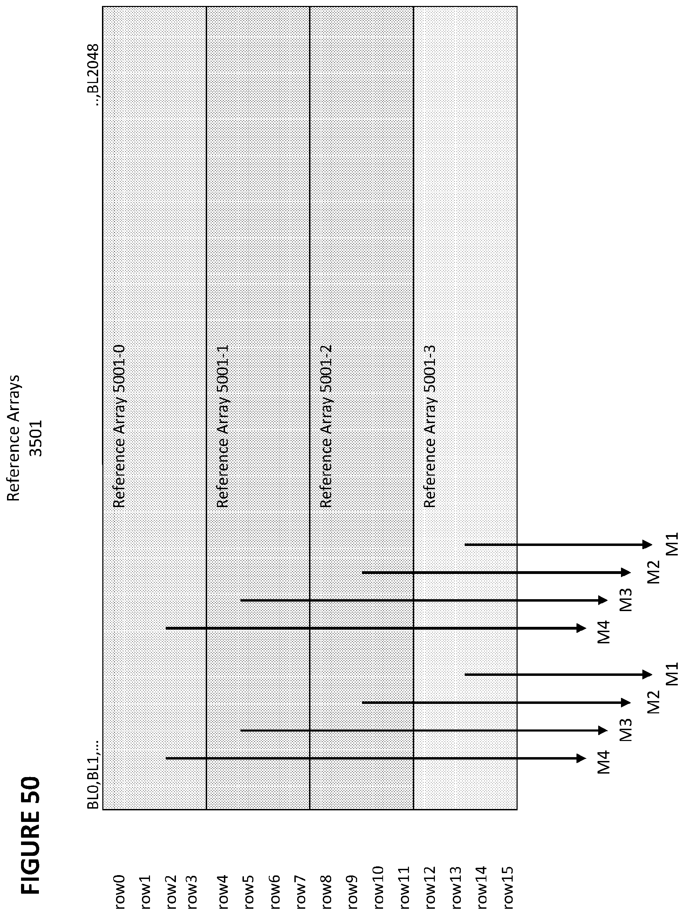

Figure 50 depicts an example layout of reference arrays 3501. Reference arrays 3501 comprise reference arrays 5001-0, 5001-1, 5001-2, and 5001-3, which are coupled to respective bitlines in different metal layers, such as metal layers M4, M3, M2, and M1, respectively. Respective reference arrays 4901, for example, implement low level (VREFL), middle level (VREFM), or high level (VREFH) CG reference biases described above in relation to Figure 44-46, without limitation.

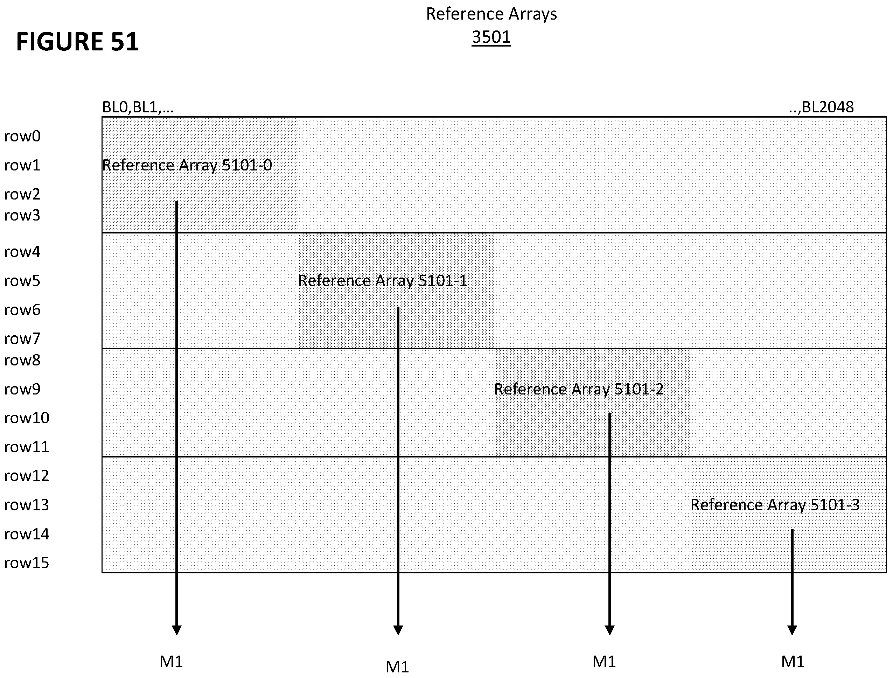

Figure 51 depicts an example layout of reference arrays 3501. Reference arrays 3501 comprise reference arrays 5101-0, 5101-1, 5101-2, and 5101-3, which are respectively coupled to bitlines in the same metal layer, such as metal layer M1. Respective reference arrays 4901, for example, implement low level (VREFL), middle level (VREFM), or high level (VREFH) CG reference biases described above in relation to Figure 44-46, without limitation. Here, each bit line is electrically coupled to only one of the reference arrays and is electrically disconnected from the other reference arrays.

It should be noted that, as used herein, the terms "over" and "on" both inclusively include "directly on" (no intermediate materials, elements or space disposed therebetween) and "indirectly on" (intermediate materials, elements or space disposed therebetween). Likewise, the term "adjacent" includes "directly adjacent" (no intermediate materials, elements or space disposed therebetween) and "indirectly adjacent" (intermediate materials, elements or space disposed there between), "mounted to" includes "directly mounted to" (no intermediate materials, elements or space disposed there between) and "indirectly mounted to" (intermediate materials, elements or spaced disposed there between), and "electrically coupled" includes "directly electrically coupled to" (no intermediate materials or elements there between that electrically connect the elements together) and "indirectly electrically coupled to" (intermediate materials or elements there between that electrically connect the elements together). For example, forming an element "over a substrate" can include forming the element directly on the substrate with no intermediate materials/elements therebetween, as well as forming the element indirectly on the substrate with one or more intermediate materials/elements there between.

## Claims

1. A system comprising an artificial neural network, the artificial neural network comprising:
a vector-by-matrix multiplication array (3401); and
a plurality of reference arrays (3501) distinguished by different I-V curves, wherein the system is configured to select one or more of the plurality of reference arrays during a calibration process and thereafter use the one or more selected reference arrays to generate an input voltage to be applied to the vector-by-matrix multiplication array during operation, and wherein the respective reference arrays of the plurality of reference arrays differ from one another in at least one dimension of physical measurement, at least one doping characteristic, at least one well implant derived electrical characteristic, or a combination thereof.

2. The system of claim 1, comprising a control circuit providing a target current through reference cells of the one or more of the plurality of reference arrays to generate the input voltage.

3. The system of claim 1, wherein the dimension is a width of a control gate line of transistors of the respective reference array; or
wherein the dimension is a width of a word line of transistors of the respective reference array; or
wherein the dimension is a width of a floating gate of transistors of the respective reference array; or
wherein the dimension is an overall width of a non-volatile memory cell in the respective reference array; or
wherein the dimension is a shallow trench isolation spacing of transistors of the respective reference array.

4. The system of claim 1, wherein the plurality of reference arrays and the vector-by-matrix multiplication array comprise non-volatile memory cells.

5. The system of claim 4, wherein the non-volatile memory cells are stacked-gate flash memory cells; or wherein the non-volatile memory cells are split-gate flash memory cells.

6. The system of claim 1, wherein the reference arrays generate a bias for the vector-by-matrix multiplication array.

7. The system of claim 1, wherein the reference arrays generate a bias for rows of the vector-by-matrix multiplication array.

8. The system of claim 1, wherein the plurality of reference arrays and the vector-by-matrix multiplication array are in a same physical array.

9. The system of claim 1, wherein the plurality of reference arrays and the vector-by-matrix multiplication array are in different physical arrays.

10. A method comprising:
selecting a plurality of reference arrays (3501) distinguished by different I-V curves as candidates for a calibration process;
determining a metric for the plurality of reference arrays (3501), wherein the respective reference arrays of the plurality of reference arrays differ from one another in at least one dimension of physical measurement, at least one doping characteristic, at least one well implant derived electrical characteristic, or a combination thereof;
identifying a reference array in the plurality of reference arrays for which the determined metric is closest to a target value; using the identified reference array for a calibration of a vector-by-matrix multiplication array (3401), wherein the calibration comprises generating a bias voltage and applying the bias voltage to memory cells in the vector-by-matrix multiplication array.

11. The method of claim 10, wherein the plurality of reference arrays and the vector-by-matrix multiplication array are in a same physical array; or
wherein the plurality of reference arrays and the vector-by-matrix multiplication array are in different physical arrays.

12. The method of claim 10, wherein the reference array is used to generate a bias for rows of the vector-by-matrix multiplication array; or
wherein the plurality of reference arrays and the vector-by-matrix multiplication array comprise non-volatile memory cells.

13. The method of claim 10, wherein the plurality of reference arrays and the vector-by-matrix multiplication array comprise non-volatile stacked-gate flash memory cells.

14. The method of claim 10, wherein the plurality of reference arrays and the vector-by-matrix multiplication array comprise non-volatile split-gate flash memory cells.

## Patentansprüche

1. System, umfassend ein künstliches neuronales Netzwerk, wobei das künstliche neuronale Netzwerk umfasst:
ein Vektor-mal-Matrix-Multiplikationsarray (3401); und
eine Vielzahl von Referenzarrays (3501), die sich durch unterschiedliche I-V-Kurven auszeichnen, wobei das System konfiguriert ist, um eines oder mehrere der Vielzahl von Referenzarrays während eines Kalibrierungsprozesses auszuwählen und anschließend das eine oder die mehreren ausgewählten Referenzarrays zu verwenden, um eine Eingangsspannung zu erzeugen, die während des Betriebs an das Vektor-mal-Matrix-Multiplikationsarray angelegt werden soll, und wobei sich die jeweiligen Referenzarrays der Vielzahl von Referenzarrays voneinander in mindestens einer Dimension einer physikalischen Messung, mindestens einer Dotierungscharakteristik, mindestens einer aus Wannenimplantation abgeleiteten elektrischen Charakteristik oder einer Kombination davon unterscheiden.

2. System nach Anspruch 1, umfassend eine Steuerschaltung, die einen Sollstrom durch Referenzzellen des einen oder der mehreren der Vielzahl von Referenzarrays bereitstellt, um die Eingangsspannung zu erzeugen.

3. System nach Anspruch 1, wobei die Dimension eine Breite einer Steuergate-Leitung von Transistoren des jeweiligen Referenzarrays ist; oder
wobei die Dimension eine Breite einer Wortleitung von Transistoren des jeweiligen Referenzarrays ist; oder
wobei die Dimension eine Breite eines Floating-Gate von Transistoren des jeweiligen Referenzarrays ist; oder
wobei die Dimension eine Gesamtbreite einer nichtflüchtigen Speicherzelle in dem jeweiligen Referenzarray ist; oder
wobei die Dimension ein Shallow-Trench-Isolation-Abstand von Transistoren des jeweiligen Referenzarrays ist.

4. System nach Anspruch 1, wobei die Vielzahl von Referenzarrays und das Vektor-mal-Matrix-Multiplikationsarray nichtflüchtige Speicherzellen umfassen.

5. System nach Anspruch 4, wobei die nichtflüchtigen Speicherzellen Stacked-Gate-Flash-Speicherzellen sind; oder
wobei die nichtflüchtigen Speicherzellen Split-Gate-Flash-Speicherzellen sind.

6. System nach Anspruch 1, wobei die Referenzarrays eine Vorspannung für das Vektor-mal-Matrix-Multiplikationsarray erzeugen.

7. System nach Anspruch 1, wobei die Referenzarrays eine Vorspannung für Zeilen des Vektor-mal-Matrix-Multiplikationsarrays erzeugen.

8. System nach Anspruch 1, wobei sich die Vielzahl von Referenzarrays und das Vektor-mal-Matrix-Multiplikationsarray in einem gleichen physischen Array befinden.

9. System nach Anspruch 1, wobei sich die Vielzahl von Referenzarrays und das Vektor-mal-Matrix-Multiplikationsarray in unterschiedlichen physischen Arrays befinden.

10. Verfahren, umfassend:
Auswählen einer Vielzahl von Referenzarrays (3501), die sich durch unterschiedliche I-V-Kurven auszeichnen, als Kandidaten für einen Kalibrierungsprozess;
Bestimmen einer Metrik für die Vielzahl von Referenzarrays (3501), wobei sich die jeweiligen Referenzarrays der Vielzahl von Referenzarrays voneinander in mindestens einer Dimension einer physikalischen Messung, mindestens einer Dotierungscharakteristik, mindestens einer aus Wannenimplantation abgeleiteten elektrischen Charakteristik oder einer Kombination davon unterscheiden;
Identifizieren eines Referenzarrays in der Vielzahl von Referenzarrays, für das die bestimmte Metrik am nächsten an einem Zielwert liegt;
Verwenden des identifizierten Referenzarrays für eine Kalibrierung eines Vektor-mal-Matrix-Multiplikationsarrays (3401),
wobei die Kalibrierung das Erzeugen einer Vorspannung und das Anlegen der Vorspannung an Speicherzellen in dem Vektor-mit-Matrix-Multiplikationsarray umfasst.

11. Verfahren nach Anspruch 10, wobei sich die Vielzahl von Referenzarrays und das Vektor-mal-Matrix-Multiplikationsarray in einem gleichen physischen Array befinden; oder wobei sich die Vielzahl von Referenzarrays und das Vektor-mal-Matrix-Multiplikationsarray in unterschiedlichen physischen Arrays befinden.

12. Verfahren nach Anspruch 10, wobei das Referenzarray verwendet wird, um eine Vorspannung für Zeilen des Vektor-mal-Matrix-Multiplikationsarrays zu erzeugen; oder
wobei die Vielzahl von Referenzarrays und das Vektor-mal-Matrix-Multiplikationsarray nichtflüchtige Speicherzellen umfassen.

13. Verfahren nach Anspruch 10, wobei die Vielzahl von Referenzarrays und das Vektor-mal-Matrix-Multiplikationsarray nichtflüchtige Stacked-Gate-Flash-Speicherzellen umfassen.

14. Verfahren nach Anspruch 10, wobei die Vielzahl von Referenzarrays und das Vektor-mal-Matrix-Multiplikationsarray nichtflüchtige Split-Gate-Flash-Speicherzellen umfassen.

## Revendications

1. Système comprenant un réseau de neurones artificiels, le réseau de neurones artificiels comprenant :
un réseau de multiplication vecteur par matrice (3401) ; et
une pluralité de réseaux de référence (3501) distingués par différentes courbes I-V, dans lequel le système est configuré pour sélectionner un ou plusieurs réseaux parmi la pluralité de réseaux de référence pendant un processus d'étalonnage et ensuite utiliser le ou les réseaux de référence sélectionnés pour générer une tension d'entrée à appliquer au réseau de multiplication vecteur par matrice pendant un fonctionnement, et dans lequel les réseaux de référence respectifs de la pluralité de réseaux de référence diffèrent les uns des autres dans au moins une dimension de mesure physique, au moins une caractéristique de dopage, au moins une caractéristique électrique dérivée d'un implant de puits, ou une combinaison de celles-ci.

2. Système selon la revendication 1, comprenant un circuit de commande fournissant un courant cible à travers des cellules de référence du ou des réseaux de référence parmi la pluralité de réseaux de référence pour générer la tension d'entrée.

3. Système selon la revendication 1, dans lequel la dimension est une largeur d'une ligne de grille de commande de transistors du réseau de référence respectif ; ou
dans lequel la dimension est une largeur d'une ligne de mot de transistors du réseau de référence respectif ; ou
dans lequel la dimension est une largeur d'une grille flottante de transistors du réseau de référence respectif ; ou
dans lequel la dimension est une largeur globale d'une cellule de mémoire non volatile dans le réseau de référence respectif ; ou
dans lequel la dimension est un espacement d'isolation de tranchée peu profonde de transistors du réseau de référence respectif.

4. Système selon la revendication 1, dans lequel la pluralité de réseaux de référence et le réseau de multiplication vecteur par matrice comprennent des cellules de mémoire non volatile.

5. Système selon la revendication 4, dans lequel les cellules de mémoire non volatile sont des cellules de mémoire flash à grille empilée. ou
dans lequel les cellules de mémoire non volatile sont des cellules de mémoire flash à grille séparée.

6. Système selon la revendication 1, dans lequel les réseaux de référence génèrent une polarisation pour le réseau de multiplication vecteur par matrice.

7. Système selon la revendication 1, dans lequel les réseaux de référence génèrent une polarisation pour des rangées du réseau de multiplication vecteur par matrice.

8. Système selon la revendication 1, dans lequel la pluralité de réseaux de référence et le réseau de multiplication vecteur par matrice sont dans un même réseau physique.

9. Système selon la revendication 1, dans lequel la pluralité de réseaux de référence et le réseau de multiplication vecteur par matrice sont dans des réseaux physiques différents.

10. Procédé comprenant :
la sélection d'une pluralité de réseaux de référence (3501) se distinguant par différentes courbes I-V en tant que candidats à un processus d'étalonnage ;
la détermination d'une métrique pour la pluralité de réseaux de référence (3501), dans lequel les réseaux de référence respectifs de la pluralité de réseaux de référence diffèrent les uns des autres dans au moins une dimension de mesure physique, au moins une caractéristique de dopage, au moins une caractéristique électrique dérivée d'un implant de puits, ou une combinaison de celles-ci ;
l'identification d'un réseau de référence dans la pluralité de réseaux de référence pour lequel la métrique déterminée est la plus proche d'une valeur cible ;
l'utilisation du réseau de référence identifié pour un étalonnage d'un réseau de multiplication vecteur par matrice (3401),
dans lequel l'étalonnage comprend la génération d'une tension de polarisation et l'application de la tension de polarisation à des cellules de mémoire dans le réseau de multiplication vecteur par matrice.

11. Procédé selon la revendication 10, dans lequel la pluralité de réseaux de référence et le réseau de multiplication vecteur par matrice sont dans un même réseau physique ; ou dans lequel la pluralité de réseaux de référence et le réseau de multiplication vecteur par matrice sont dans des réseaux physiques différents.

12. Procédé selon la revendication 10, dans lequel le réseau de référence est utilisé pour générer une polarisation pour des rangées du réseau de multiplication vecteur par matrice ; ou
dans lequel la pluralité de réseaux de référence et le réseau de multiplication vecteur par matrice comprennent des cellules de mémoire non volatile.

13. Procédé selon la revendication 10, dans lequel la pluralité de réseaux de référence et le réseau de multiplication vecteur par matrice comprennent des cellules de mémoire flash non volatile à grille empilée.

14. Procédé selon la revendication 10, dans lequel la pluralité de réseaux de référence et le réseau de multiplication vecteur par matrice comprennent des cellules de mémoire flash non volatile à grille séparée.
